# EUROPEAN PATENT APPLICATION

(11) **EP 1 876 636 A1**
(43) Date of publication of application: **09.01.2008**
(21) Application number: 06745753.1
(22) Date of filing: 27.04.2006
(51) Int. Cl.: H01L 21/027, G03F 7/20

(54) **EXPOSURE METHOD, EXPOSURE APPARATUS, AND DEVICE PRODUCING METHOD**

(30) Priority: 28.04.2005 JP 2005131862
(71) Applicant: NIKON CORPORATION, Tokyo 100-8331 (JP)
(72) Inventor: KIDA, Yoshiki, c/o NIKON CORPORATION Intellectual Property Dept., Chiyoda-ku, Tokyo 100-8331 (JP)
(74) Representative: Viering, Jentschura & Partner
(86) International application number: PCT/JP2006/308825
(87) International publication number: WO 2006/118189

(57) **Abstract**

An exposure method includes a first step filling a liquid in a predetermined optical path space for exposure light (EL) in an optical system (PL), or for exchanging the liquid (LQ) filled in the space; a second step for successively exposing a predetermined number of substrates (P) through the liquid (LQ) filled in the optical path space or through the exchanged liquid; and a third step for judging, after the completion of the second step and based on an elapsed time elapsed after the first step, whether or not to exchange the liquid (LQ) filled in the optical path space. Exposure processing and measurement processing can be satisfactorily performed by making the liquid filled in the optical path space held in a desired state.

## Description

### TECHNICAL FIELD

The present invention relates to an exposure method and an exposure apparatus for exposing a substrate through a liquid, and a method for producing a device.

### BACKGROUND ART

An exposure apparatus, which projects a pattern formed on a mask onto a photosensitive substrate to perform the exposure, is used in the photolithography step as one of the steps of producing microdevices such as semiconductor devices and liquid crystal display devices. The exposure apparatus includes a mask stage which is movable while holding the mask and a substrate stage which is movable while holding the substrate. The pattern of the mask is projected onto the substrate to perform the exposure via a projection optical system while successively moving the mask stage and the substrate stage. In the microdevice production, it is required to realize a fine and minute pattern to be formed on the substrate in order to achieve a high density of the device. In order to respond to this requirement, it is demanded to realize a higher resolution of the exposure apparatus. A liquid immersion exposure apparatus, in which the optical path space for the exposure light beam is filled with a liquid to expose the substrate through the liquid, has been contrived as one of means to realize the high resolution, as disclosed in International Publication No. 99/49504.

### DISCLOSURE OF THE INVENTION

### Task to Be Solved by the Invention:

In the liquid immersion exposure apparatus, it is important that the liquid, which is filled in the optical path space, is in a desired state. For example, if the liquid does not have a desired temperature, then the state of the optical path for the exposure light beam to pass through the liquid may be fluctuated, and/or a member, which makes contact with the liquid, may be thermally deformed. There is such a possibility that the exposure accuracy and the measurement accuracy may be deteriorated. If the liquid is polluted, then the exposure light beam, which has passed through the liquid, has its light amount which may be lowered on the substrate, and/or the member, which makes contact with the liquid, may be polluted. There is also such a possibility that the exposure accuracy and the measurement accuracy may be deteriorated.

The present invention has been made taking the foregoing circumstances into consideration, an object of which is to provide an exposure method, an exposure apparatus, and a method for producing a device, wherein the liquid, which is filled in the optical path space, is allowed to be in a desired state so that the exposure process and the measurement process can be performed satisfactorily.

### Solution for the Task:

In order to achieve the object as described above, the present invention adopts the following constructions corresponding to respective drawings as illustrated in embodiments. However, parenthesized reference numerals affixed to respective elements merely exemplify the elements by way of example, with which it is not intended to limit the respective elements.

According to a first aspect of the present invention, there is provided an exposure method for exposing a substrate (P) by radiating an exposure light beam (EL) onto the substrate (P) via an optical system (PL) having a first optical element (LS1) which is arranged opposite to or facing the substrate and a second optical element (LS2); the exposure method comprising a first step for filling, with a liquid (LQ), a predetermined optical path space (for example, K1) for the exposure light beam (EL) in the optical system (PL) or exchanging the liquid (LQ) filled in the optical path space; a second step for successively exposing, after the first step, a predetermined number of the substrate (P) through the liquid (LQ) filled in the optical path space (for example, K1); and a third step for judging, after the second step, whether or not the liquid (LQ) filled in the optical path space (for example, K1) is to be exchanged based on an elapsed time elapsed after the first step has been performed.

According to the first aspect of the present invention, the liquid is successfully allowed to be in a desired state, and it is possible to satisfactorily perform the exposure process and the measurement process, because it is judged whether or not the liquid is exchanged based on the elapsed time elapsed after the optical path space has been filled with the liquid or after the liquid filled in the optical path space has been exchanged.

According to a second aspect of the present invention, there is provided an exposure method for exposing a substrate (P) by radiating an exposure light beam (EL) onto the substrate (P) via an optical system (PL) having a first optical element (LS1) which is arranged opposite to or facing the substrate (P) and a second optical element (LS2); the exposure method comprising a liquid exchange step for exchanging, at a predetermined time interval, the liquid (LQ) filled in a predetermined optical path space (for example, K1) for the exposure light beam (EL) in the optical system (PL), when the exposure light beam (EL) is not radiated; and an exposure step for exposing the substrate (P) by radiating the exposure light beam (EL) via the predetermined optical path space (for example, K1) filled with the liquid, after exchanging the liquid at the predetermined time interval.

According to the second aspect of the present invention, the liquid filled in the optical path space is exchanged at the predetermined time interval, even when the exposure light beam is not radiated. Accordingly, the liquid is successfully allowed to be in a desired state, and it is possible to satisfactorily perform the exposure process and the measurement process.

According to a third aspect of the present invention, there is provided an exposure method for exposing a substrate (P) by radiating an exposure light beam (EL) onto the substrate (P) through a liquid (LQ); the exposure method comprising exchanging the liquid (LQ); performing measurement in relation to an exposure process through the exchanged liquid; and exposing, after the measurement, the substrate by radiating the exposure light beam onto the substrate (P) through the exchanged liquid (LQ).

According to the third aspect of the present invention, the liquid is successfully allowed to be in a desired state by exchanging the liquid and then performing the measurement. Further, the exposure process is performed for the substrate based on a result of the measurement. Accordingly, the exposure process for the substrate can be executed highly accurately even after the exchange of the liquid.

According to a fourth aspect of the present invention, there is provided a method for producing a device, comprising exposing a substrate by using the exposure method as defined in any one of the first to third aspects; developing the exposed substrate; and processing the developed substrate.

According to the fourth aspect of the present invention, the device having desired performance can be produced by using the exposure method which makes it possible to expose the substrate accurately.

According to a fifth aspect of the present invention, there is provided an exposure apparatus (EX) which exposes a substrate (P) by radiating an exposure light beam (EL) onto the substrate (P) via an optical system (PL) having a first optical element (LS1) which is arranged opposite to or facing the substrate and a second optical element (LS2); the exposure apparatus (EX) comprising a first liquid immersion mechanism (for example, 1) which fills, with a liquid (LQ), a predetermined optical path space (for example, K1) for the exposure light beam (EL) in the optical system (PL) and which exchanges, at a predetermined timing, the liquid (LQ) filled in the optical path space (K1); and a controller (CONT) which controls the first liquid immersion mechanism (1); wherein the controller (CONT) controls the first liquid immersion mechanism (for example, 1) to fill the optical path space (K1) with the liquid or to exchange the liquid (LQ) filled in the optical path space (K1) at a first point of time, and then the controller (CONT) performs an exposure process for successively exposing a predetermined number of the substrate (P) through the liquid (LQ) which is filled in the optical path space (for example, K1) or which is exchanged; and the controller (CONT) judges, after completing the exposure for the predetermined number of the substrate (P), whether or not the liquid (LQ) in the optical path space (K1) is to be exchanged by using the first liquid immersion mechanism (1) based on an elapsed time elapsed after the first point of time.

According to the fifth aspect of the present invention, it is judged whether or not the liquid is exchanged based on the elapsed time elapsed after or from the first point of time at which the optical path space is filled with the liquid or the liquid filled in the optical path space is exchanged. Therefore, the liquid is successfully allowed to be in a desired state, and it is possible to satisfactorily perform the exposure process and the measurement process.

According to a sixth aspect of the present invention, there is provided an exposure apparatus (EX) which exposes a substrate (P) by radiating an exposure light beam (EL) onto the substrate (P) via an optical system (PL) having a first optical element (LS1) which is arranged opposite to or facing the substrate and a second optical element (LS2); the exposure apparatus (EX) comprising a first liquid immersion mechanism (for example, 1) which fills, with a liquid (LQ), an optical path space (for example, K1) for the exposure light beam (EL) in the optical system (PL) and which exchanges the liquid (LQ) filled in the optical path space (for example, K1); and a controller (CONT) which controls the first liquid immersion mechanism (for example, 1) to exchange the liquid (LQ) filled in the optical path space (K1) at a predetermined time interval when the exposure light beam (EL) is not radiated.

According to the sixth aspect of the present invention, the liquid, which is filled in the optical path space, is exchanged at the predetermined time interval when the exposure light beam is not radiated. Accordingly, the liquid is successfully allowed to be in a desired state, and it is possible to satisfactorily perform the exposure process and the measurement process.

According to a seventh aspect of the present invention, there is provided an exposure apparatus (EX) which exposes a substrate (P) by radiating an exposure light beam (EL) onto the substrate (P) via an optical system (PL) having a first optical element (LS1) and a second optical element (LS2); the exposure apparatus (EX) comprising a first liquid immersion mechanism (1) which fills, with a liquid (LQ), an optical path space (K1) for the exposure light beam (EL) between the first optical element (LS1) and the second optical element (LS1) and which exchanges the liquid (LQ) filled in the optical path space (K1); a measuring device (for example, 160) which is arranged on a side of a light-exit surface of the first optical element (LS1) and which receives the exposure light beam (EL) through the liquid (LQ) between the first optical element (LS1) and the second optical element (LS2) to perform predetermined measurement in relation to an exposure process; and a controller (CONT) which controls the first liquid immersion mechanism (1) to execute an exchange operation for the liquid (LQ) and which controls the measuring device (for example, 160) to execute the measurement before starting the exposure for a next substrate (P), after the exchange operation for the liquid (LQ).

According to the seventh aspect of the present invention, the liquid between the first optical element and the second optical element is exchanged by the first liquid immersion mechanism. The state of the exposure light beam allowed to pass through the liquid after the exchange can be grasped by the measuring device. Further, the exposure process for the substrate, which is to be performed thereafter, can be executed highly accurately based on a result of the measurement performed by the measuring device.

According to an eighth aspect of the present invention, there is provided an exposure apparatus (EX) which exposes a substrate (P) by radiating an exposure light beam (EL) onto the substrate (P) through a liquid (LQ); the exposure apparatus (EX) comprising a liquid immersion mechanism (1 or 2) which exchanges the liquid (LQ); and a measuring device (for example, 160) which performs measurement in relation to an exposure process by receiving the exposure light beam (EL) through the liquid (LQ), after the liquid is exchanged.

According to the eighth aspect of the present invention, the liquid is successfully allowed to be in a desired state by exchanging the liquid by the liquid immersion mechanism and then performing the measurement with the measuring device. Further, the exposure process for the substrate, which is to be performed thereafter, can be executed highly accurately based on a result of the measurement.

According to a ninth aspect of the present invention, there is provided a method for producing a device, comprising exposing a substrate by using the exposure apparatus (EX) as defined in any one of the fifth to eighth aspects; developing the exposed substrate; and processing the developed substrate.

According to the ninth aspect of the present invention, the device having desired performance can be produced by using the exposure apparatus which makes it possible to expose the substrate accurately.

### Effect of the Invention:

According to the present invention, the exposure process and the measurement process can be performed satisfactorily. Further, it is possible to produce the device having the desired performance.

### BRIEF DESCRIPTION OF THE DRAWINGS

Fig. 1 shows a schematic arrangement view illustrating an embodiment of the exposure apparatus.
Fig. 2 illustrates first and second liquid immersion mechanisms.
Fig. 3 illustrates the first liquid immersion mechanism.
Fig. 4 shows a side sectional view illustrating a substrate holder.
Fig. 5 shows a plan view illustrating a substrate stage and a measuring stage.
Fig. 6 shows a plan view illustrating a part of the substrate holder.
Fig. 7 shows a side sectional view illustrating a liquid recovery mechanism provided for the substrate holder.
Fig. 8 shows an observing device.
Fig. 9 schematically illustrates a situation in which a liquid immersion area on a side of an image plane (image plane-side liquid immersion area) is moved between the substrate stage and the measuring stage.
Fig. 10 schematically shows a situation in which the observing device observes a liquid immersion area on a side of an object plane (object plan-side liquid immersion area).
Fig. 11 schematically shows a situation in which the observing device observes the image plane-side liquid immersion area.
Fig. 12 shows a plan view illustrating an example of the operation of the substrate stage and the measuring stage.
Fig. 13 shows a plan view illustrating an example of the operation of the substrate stage and the measuring stage.
Fig. 14 shows a plan view illustrating an example of the operation of the substrate stage and the measuring stage.
Fig. 15 shows a plan view illustrating an example of the operation of the substrate stage and the measuring stage.
Fig. 16 shows a plan view illustrating an example of the operation of the substrate stage and the measuring stage.
Fig. 17 shows a flow chart illustrating an embodiment of the exposure method.
Fig. 18 shows a flow chart continued from the flow chart shown in Fig. 17.
Fig. 19 shows a flow chart illustrating a procedure of initial filling operation for a space on a side of the object plane (object plane-side space).
Fig. 20 shows a flow chart illustrating a procedure of initial filling operation for a space on a side of the image plane (image plane-side space).
Fig. 21 shows a flow chart illustrating a procedure of an operation for exposing substrates of a first lot.
Fig. 22 shows a flow chart illustrating a procedure of an operation for exchanging the liquid in the object plane-side space.
Fig. 23 shows a flow chart illustrating a procedure of full recovery operation for the liquid in the image plane-side space.
Figs. 24(A) and 24(B) show another embodiment of the liquid recovery mechanism.
Fig. 25 shows a flow chart illustrating exemplary steps of producing a microdevice.

### Legend of Reference Numerals:

1: first liquid immersion mechanism, 2: second liquid immersion mechanism, 160: spatial image-measuring sensor (measuring device), CONT: controller, EL: exposure light beam, EX: exposure apparatus, K1: object plane-side space, K2: image plane-side space, LQ: liquid, LS1: first optical element, LS2: second optical element, P: substrate, PL: projection optical system.

### BEST MODE FOR CARRYING OUT THE INVENTION

Embodiments of the present invention will be explained below with reference to the drawings. However, the present invention is not limited thereto.

### First Embodiment

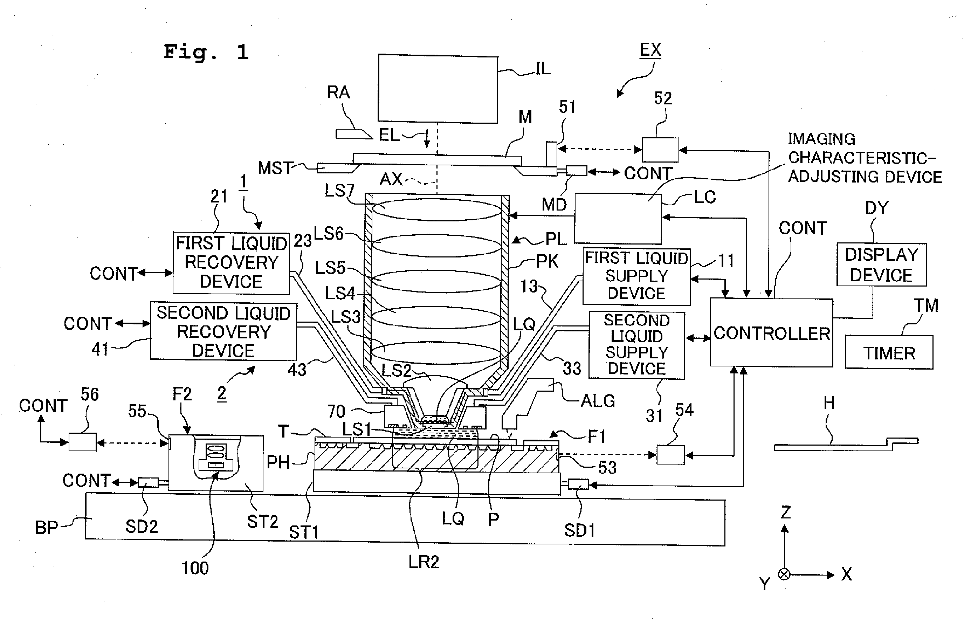

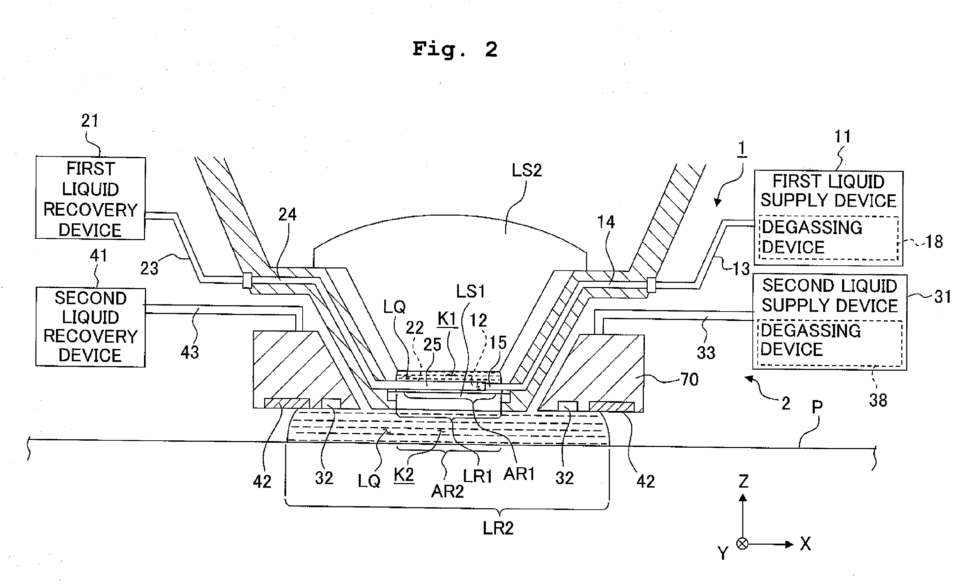

Fig. 1 shows a schematic arrangement view illustrating an embodiment of the exposure apparatus EX. Fig. 2 shows a magnified view illustrating main components shown in Fig. 1. With reference to Figs. 1 and 2, the exposure apparatus EX includes a mask stage MST which is movable while holding a mask M, a substrate holder PH which holds a substrate P, a substrate stage ST1 which is capable of moving the substrate holder PH that holds the substrate P, a measuring stage ST2 which is movable while carrying a measuring device performing the measurement in relation to the exposure process, an illumination optical system IL which illuminates, with an exposure light beam EL, the mask M placed on the mask stage MST, a projection optical system PL which projects an image of a pattern of the mask M illuminated with the exposure light beam EL onto the substrate P placed on the substrate stage ST1 to perform the exposure, and a controller CONT which integrally controls the operation of the entire exposure apparatus EX. Those connected to the controller CONT include a display device DY which displays information about the exposure process, and a timer TM which measures the time. The substrate stage ST1 and the measuring stage ST2 are movable independently from each other on a base member BP on a side of the image plane (mage plane-side) of the projection optical system PL respectively. The exposure apparatus EX further includes a transport device H which transports the substrate P with respect to the substrate holder PH.

The exposure apparatus EX of the embodiment of the present invention is the liquid immersion exposure apparatus to which the liquid immersion method is applied in order that the exposure wavelength is substantially shortened to improve the resolution and the depth of focus is substantially widened. The exposure apparatus EX includes a first liquid immersion mechanism 1 which fills, with a liquid LQ, an optical path space K1 for the exposure light beam EL between a first optical element LS1 closest to the image plane of the projection optical system PL and a second optical element LS2 next closest to the image plane of the projection optical system PL with respect to the first optical element LS1, the first optical element LS1 and the second optical element LS2 being included in a plurality of optical elements LS1 to LS7 constructing the projection optical system PL, and a second liquid immersion mechanism 2 which fills, with the liquid LQ, an optical path space K2 for the exposure light beam EL between the first optical element LS1 and an object (at least a part of the substrate P, the substrate stage ST1, and the measuring stage ST2) arranged on the image plane-side of the first optical element LS1. The second optical element LS2 is arranged over or above (on the +Z side of) the first optical element LS1. The upper surface of the first optical element LS1 is arranged opposite to or facing the lower surface of the second optical element LS2. The operations of the first liquid immersion mechanism 1 and the second liquid immersion mechanism 2 are controlled by the controller CONT.

In the following description, the optical path space K1, which is the optical path space on a side of the object plane (object plane-side) of the projection optical system PL with respect to the first optical element LS1 and which is between the first optical element LS1 and the second optical element LS2, is appropriately referred to herein as "object plane-side space K1". The optical path space K2, which is the optical path space on the image plane-side of the projection optical system PL with respect to the first optical element LS1 and which is between the first optical element LS1 and an object (at least a part of the substrate P, the substrate stage ST1, and the measuring stage ST2) arranged on the image plane-side of the first optical element LS1, is appropriately referred to herein as "image plane-side space K2". In this embodiment, the object plane-side space K1 and the image plane-side space K2 are independent spaces. Neither inflow nor outflow of the liquid LQ occurs from one to the other of the object plane-side space K1 and the image plane-side space K2.

The exposure apparatus EX transfers the pattern of the mask M to the substrate P by radiating the exposure light beam EL, allowed to pass through the mask M, onto the substrate P via the projection optical system PL, the liquid LQ with which the object plane-side space K1 is filled, and the liquid LQ with which the image plane-side space K2 is filled.

The first liquid immersion mechanism 1 is provided with a supply member 15 which is provided in the vicinity of the object plane-side space K1 and which has a supply port 12 supplying the liquid LQ; a first liquid supply device 11 which supplies the liquid LQ to the object plane-side space K1 via a supply tube 13, a supply flow passage 14, and the supply port 12 provided for the supply member 15; a recovery member 25 which is provided in the vicinity of the object plane-side space K1 and which has a recovery port 22 recovering the liquid LQ; and a first liquid recovery device 21 which recovers the liquid LQ in the object plane-side space K1 via the recovery ports 22 provided for the recovery member 25, a recovery flow passage 24, and a recovery tube 23.

The second liquid immersion mechanism 2 is provided with a nozzle member 70 which is provided in the vicinity of the image plane-side space K2 and which has a supply port 32 supplying the liquid LQ and a recovery port 42 recovering the liquid LQ; a second liquid supply device 31 which supplies the liquid LQ to the image plane-side space K2 via a supply tube 33 and the supply port 32 provided for the nozzle member 70; and a second liquid recovery device 41 which recovers the liquid LQ in the image plane-side space K2 via the recovery port 42 provided for the nozzle member 70 and a recovery tube 43. The nozzle member 70 is formed to have an annular form to surround the vicinity of the image plane-side of the projection optical system PL.

The exposure apparatus EX fills the object plane-side space K1 with the liquid LQ to form a liquid immersion area LR1 by using the first liquid immersion mechanism 1 and the exposure apparatus EX fills the image plane-side space K2 with the liquid LQ to form a liquid immersion area LR2 by using the second liquid immersion mechanism 2 at least during a period of time in which an image of the pattern (pattern image) of the mask M is projected onto the substrate P. In the following description, the liquid immersion area LR1, which is formed by the liquid LQ filled in the object plane-side space K1 between the first optical element LS1 and the second optical element LS2, is appropriately referred to as "object plane-side liquid immersion area LR1". The liquid immersion area LR2, which is formed by the liquid LQ filled in the image plane-side space K2 between the first optical element LS1 and the object (at least a part of the substrate P, the substrate stage ST1, and the measuring stage ST2) arranged on the image plane-side of the first optical element LS1, is appropriately referred to as "image plane-side liquid immersion area LR2".

In the following description, any explanation will be made in some cases assuming that the image plane-side liquid immersion area LR2 is formed on a part of the substrate P. However, as described above, the image plane-side liquid immersion area LR2 is formed on the object arranged at the position opposite to or facing the first optical element LS1 on the image plane-side of the projection optical system PL, i.e., on at least a part of the substrate P, the upper surface F1 of the substrate stage ST1, and the upper surface F2 of the measuring stage ST2.

In this embodiment, the exposure apparatus EX adopts the local liquid immersion system wherein the image plane-side liquid immersion area LR2, which is larger than the projection area AR2 and which is smaller than the substrate P, is locally formed on a part, of the substrate P, including the projection area AR2 of the projection optical system PL by using the second liquid immersion mechanism 2. Further, in this embodiment, the exposure apparatus EX locally forms the object plane-side liquid immersion area LR1 in only a partial area of the upper surface of the first optical element LS1 including the predetermined area AR1 through which the exposure light beam EL is allowed to pass, by using the first liquid immersion mechanism 1.

The embodiment of the present invention will be explained as exemplified by a case using a scanning type exposure apparatus (so-called scanning stepper) as the exposure apparatus EX in which the substrate P is exposed with the pattern formed on the mask M while synchronously moving the mask M and the substrate P in a predetermined scanning directions. In the following explanation, an Y axis direction is a synchronous movement direction (scanning direction) for the mask M and the substrate P in a horizontal plane, an X axis direction is a direction (non-scanning direction) which is perpendicular to the Y axis direction in the horizontal plane, and a Z axis direction is a direction which is perpendicular to the X axis direction and the Y axis direction and which is coincident with the optical axis AX of the projection optical system PL. The directions of rotation (inclination) about the X axis, the Y axis, and the Z axis are designated as θX, θY, and θZ directions respectively. The term "substrate" includes those obtained by entirely or partially coating, for example, various types of films such as a photosensitive material (resist) and a protective film (liquid-repellent film) on a semiconductor wafer, and the term "mask" includes a reticle on which a device pattern to be subjected to the reduction projection onto the substrate is formed.

The illumination optical system IL includes, for example, an exposure light source which radiates the exposure light beam EL, an optical integrator which uniformizes the illuminance of the exposure light beam EL radiated from the exposure light source, a condenser lens which collects the exposure light beam EL from the optical integrator, a relay lens system, and a field diaphragm which defines the illumination area on the mask M illuminated with the exposure light beam EL. A predetermined illumination area on the mask M is illuminated with the exposure light beam EL having a uniform illuminance distribution by the illumination optical system IL. Those usable as the exposure light beam EL radiated from the exposure light source include, for example, emission lines (g-ray, h-ray, i-ray) radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the F₂ laser beam (wavelength: 157 nm). In this embodiment, the ArF excimer laser beam is used.

In this embodiment, pure or purified water is used as the liquid LQ to be supplied from each of the first liquid supply device 11 and the second liquid supply device 31. That is, in this embodiment, the liquid LQ, with which the object plane-side space K1 is filled, is the same liquid as the liquid LQ with which the image plane-side space K2 is filled. Not only the ArF excimer laser beam but also the emission line (g-ray, h-ray, i-ray) radiated, for example, from a mercury lamp and the far ultraviolet light beam (DUV light beam) such as the KrF excimer laser beam (wavelength: 248 nm) are transmissive through pure water.

The mask stage MST is movable while holding the mask M. The mask stage MST holds the mask M, for example, by the vacuum attraction. The mask stage MST is finely rotatable in the θZ direction and two-dimensionally movable in the plane perpendicular to the optical axis AX of the projection optical system PL, i.e., in the XY plane. The mask stage MST is driven by a mask stage-driving device MD including, for example, a linear motor. The mask stage-driving device MD is controlled by the controller CONT. A movement mirror 51 is fixedly secured onto the mask stage MST. A laser interferometer 52 is provided at a position opposite to the movement mirror 51. The position in the two-dimensional direction and the angle of rotation in the θZ direction (including the angles of rotation in the θX and θY directions in some cases as well) of the mask M on the mask stage MST are measured in real-time by the laser interferometer 52. The result of the measurement performed by the laser interferometer 52 is outputted to the controller CONT. The controller CONT controls the position of the mask M held by the mask stage MST by driving the mask stage-driving device MD based on the measurement result of the laser interferometer 52.

The projection optical system PL projects the image of the pattern of the mask M onto the substrate P at a predetermined projection magnification β. The projection optical system PL includes a plurality of optical elements LS1 to LS7. The plurality of optical elements LS1 to LS7 are supported by a barrel PK. In this embodiment, the projection optical system PL is a reduction system having the projection magnification β which is, for example, 1/4, 1/5, or 1/8. The projection optical system PL may be any one of the 1x magnification system and the magnifying system. The projection optical system PL may be the catadioptric system including catoptric and dioptric elements. Alternatively, the projection optical system PL may be the dioptric system including no catoptric element. The exposure light beam EL, which is radiated from the illumination optical system IL, comes into the projection optical system PL from the object plane-side, and the exposure light beam EL passes through the plurality of optical elements LS7 to LS1. After that, the exposure light beam EL exits from the image plane-side of the projection optical system PL, and the exposure light beam EL arrives at a surface of the substrate P. Specifically, the exposure light beam EL passes through each of the plurality of optical elements LS7 to LS3, and then the exposure light beam EL passes through a predetermined area of the upper surface of the second optical element LS2. Afterwards, the exposure light beam EL passes through a predetermined area of the lower surface of the second optical element LS2, and then the exposure light beam EL comes into the liquid LQ filled in the object plane-side space K1. The exposure light beam EL, which has passed through the liquid LQ of the object plane-side space K1, passes through the predetermined area AR1 of the upper surface of the first optical element LS1, and then the exposure light beam EL passes through the predetermined area of the lower surface of the first optical element LS1. Afterwards, the exposure light beam EL comes into the liquid LQ filled in the image plane-side space K2, and then the exposure light beam EL arrives at the surface of the substrate P.

The first optical element LS1 and the second optical element LS2 are held by the barrel PK in a state in which they are allowed to substantially stand still with respect to the optical path for the exposure light beam EL. In this embodiment, the first optical element LS1 is held in a state that the first optical element LS1 can be easily attached and detached with respect to the barrel PK so that the first optical element LS1 is opposite to the substrate P. That is, the first optical element LS1 is provided exchangeably. Therefore, when the first optical element LS1 is polluted or dirtied, the polluted first optical element LS1 is exchanged with a clean first optical element LS1. Accordingly, it is possible to avoid the deterioration of the accuracy of the exposure and the measurement to be performed via the first optical element LS1, which would be otherwise caused by the pollution of the first optical element LS1.

In this embodiment, the first optical element LS1 is a plane-parallel which has no refractive power and through which the exposure light beam EL is transmissive. The lower surface and the upper surface of the first optical element LS1 are substantially parallel to each other. On the other hand, the second optical element LS2 has a refractive power (lens function). The upper surface of the second optical element LS2 is formed to be convex toward the object plane-side (side of the mask M), and has a positive refractive index. Accordingly, the reflection loss of the light beam (exposure light beam EL) allowed to come into the upper surface of the second optical element LS2 is reduced. Consequently, a large numerical aperture on the image side is secured. Further, the second optical element LS2, which has the refractive index (lens function), is held by the barrel PK in a state that the second optical element LS2 is positioned satisfactorily. The lower surface of the second optical element LS2 is formed to have a flat surface form. The lower surface of the second optical element LS2 held by the barrel PK is substantially parallel to the upper surface of the first optical element LS1 held by the barrel PK. It is also allowable that the first optical element LS1 has a refractive power.

The projection optical system PL is provided with an imaging characteristic-adjusting device LC which is capable of adjusting the imaging characteristic of the projection optical system PL as disclosed, for example, in Japanese Patent Application Laid-open Nos. 60-78454 and 11-195602 and International Publication No. 03/65428. The imaging characteristic-adjusting device LC includes an optical element-driving mechanism which is capable of moving a part or parts of the plurality of optical elements constructing the projection optical system PL. The optical element-driving mechanism is capable of moving a specific optical element, of the plurality of optical elements constructing the projection optical system PL, in the direction of the optical axis AX (Z axis direction), and it is capable of inclining the specific optical element with respect to the optical axis AX. The imaging characteristic-adjusting device LC is capable of adjusting the imaging characteristic including, for example, various types of distortions (for example, the projection magnification, the distortion, and the spherical aberration) and the image plane position (focus position) of the projection optical system PL by driving the specific optical element of the plurality of optical elements constructing the projection optical system PL. As for the imaging characteristic-adjusting device LC, it is also allowable to include a pressure-adjusting mechanism which adjusts the pressure of a gas in the space between parts of the optical elements held in the barrel PK. The imaging characteristic-adjusting device LC is controlled by the controller CONT.

The substrate stage ST1 is capable of moving the substrate holder PH which holds the substrate P, on the image plane-side of the projection optical system PL. The substrate stage ST1 is provided movably on the base member BP in a state that the substrate stage ST1 supports the substrate holder PH. The substrate stage ST1 is driven by a substrate stage-driving device SD1. The substrate stage-driving device SD1 is controlled by the controller CONT. The substrate stage-driving device SD1 is provided with an XY driving device which includes, for example, a linear motor and/or the like and which moves the substrate stage ST1 in the X axis direction, the Y axis direction and the θ2 direction, and a Z driving device which includes, for example, a voice coil motor and/or the like and which moves the substrate stage ST1 in the Z axis direction, the θX direction, and the θY direction. The surface of the substrate P held by the substrate holder PH is movable in the directions of six degrees of freedom of the X axis, Y axis, Z axis, θX, θY, and θZ directions in accordance with the driving of the substrate stage ST1. A movement mirror 53 is fixedly secured to a side surface of the substrate holder PH. A laser interferometer 54 is provided at a position opposite to or facing the movement mirror 53. The angle of rotation and the position in the two-dimensional direction of the substrate P on the substrate holder PH are measured in real-time by the laser interferometer 54. The exposure apparatus EX is provided with a focus/leveling-detecting system of the oblique incidence system (not shown) which detects the surface position information about the surface of the substrate P supported by the substrate holder PH. The focus/leveling-detecting system has a light-emitting section which radiates a detecting light onto the surface of the substrate P held by the substrate holder PH, and a light-receiving section which is arranged in a predetermined positional relationship with respect to the detecting light and which receives a reflected light of the detecting light reflected by the surface of the substrate P. The focus/leveling-detecting system detects the surface position information about the surface of the substrate P (the position information in the Z axis direction and the inclination information in the θX and θY directions) based on the detection result of the light-receiving section. The result of the measurement performed by the laser interferometer 54 is outputted to the controller CONT. The result of the detection performed by the focus/leveling-detecting system is also outputted to the controller CONT. The controller CONT drives the substrate stage-driving device SD1 based on the detection result of the focus/leveling-detecting system to control the angle of inclination (θX, θY) and the focus position (Z position) of the substrate P so that positional relationship between the surface of the substrate P and the image plane of the projection optical system PL is controlled. Further, the controller CONT controls the position of the substrate P in the X axis direction, the Y axis direction, and the θZ direction based on the measurement result of the laser interferometer 53.

The measuring stage ST2 is provided with various measuring devices (including a measuring member) for performing the measurement in relation to the exposure process. The measuring stage ST2 is provided movably on the base member BP on the image plane-side of the projection optical system PL. The measuring device (including the measuring member) on the measuring stage ST2 is arranged on a side of the light-exit surface (image plane-side) of the first optical element LS1 when the projection optical system PL is opposite to the measuring stage ST2. The measuring stage ST2 is driven by a measuring stage-driving device SD2. The measuring stage-driving device SD2 is controlled by the controller CONT. The measuring stage-driving device SD2 is constructed equivalently to the substrate stage-driving device SD1.
The measuring stage ST2 is movable by the measuring stage-driving device SD2 in the X axis, Y axis, and Z axis directions and the θX, θY, and θZ directions respectively in the same manner as the substrate stage ST1. A movement mirror 55 is fixedly secured to a side surface of the measuring stage ST2. A laser interferometer 56 is provided at a position opposite to the movement mirror 55. The position in the two-dimensional direction and the angle of rotation of the measuring stage ST2 are measured in real-time by the laser interferometer 56. The controller CONT controls the position of the measuring stage ST2 based on the result of the measurement performed by the laser interferometer 56.

The controller CONT is capable of moving the substrate stage ST1 and the measuring stage ST2 mutually independently on the base member BP respectively by the aid of the stage-driving devices SD1, SD2 respectively.

A mask alignment system RA, which is constructed of an alignment system of the TTR system using a light having an exposure wavelength for simultaneously observing, via the projection optical system PL, an alignment mark on the mask M and a reference mark (first reference mark) on a reference mark plate provided on the measuring stage ST2, is provided in the vicinity of the mask stage MST. The mask alignment system RA simultaneously observes the alignment mark on the mask M and the first reference mark on the reference mark plate corresponding to the alignment mark. The mask alignment system RA of this embodiment adopts the VRA (visual reticle alignment) system in which a position of the mark is detected by radiating the light onto the mark, and by subjecting the image data of the mark, which is photographed or imaged by a CCD camera or the like, to the image processing, as disclosed, for example, in Japanese Patent Application Laid-open No. 7-176468. In this embodiment, the mask alignment system RA detects the reference mark (first reference mark) on the reference mark plate via the projection optical system PL and the liquid LQ.

An alignment system ALG of the off-axis system, which detects, for example, the alignment mark on the substrate P and a reference mark (second reference mark) on the reference mark plate provided on the measuring stage ST2, is provided in the vicinity of the end portion of the projection optical system PL. The alignment system ALG of this embodiment adopts the FIA (field image alignment) system in which the position of the mark is measured by radiating a broad band detecting light, which does not photosensitize the photosensitive material on the substrate P, onto the mark to be detected (detection-objective mark), by photographing or imaging the image of the objective mark imaged on the light-receiving surface using an image pickup element (for example, CCD) with the reflected light from the objective mark and with an image of an unillustrated index (index pattern on an index plate provided in the alignment system ALG), and by subjecting the image pickup signals of these images to the image processing, as disclosed, for example, in Japanese Patent Application Laid-open No. 4-65603. In this embodiment, the alignment system ALG is capable of detecting the alignment mark on the substrate P and the reference mark (second reference mark) on the reference mark plate not through the liquid LQ.

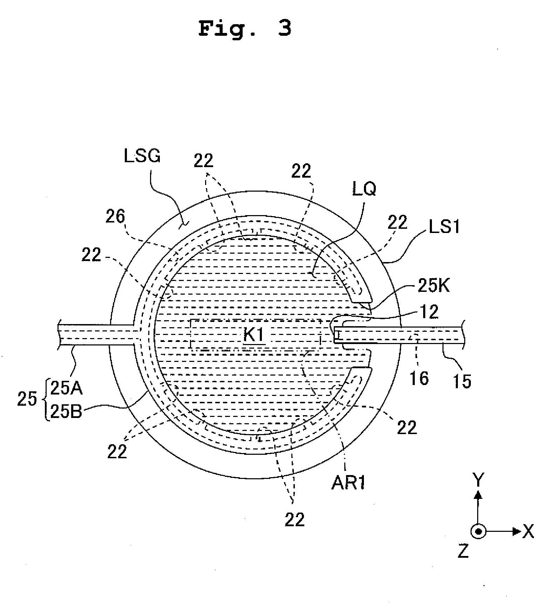

Next, the first liquid immersion mechanism 1 will be explained with reference to Figs. 2 and 3. Fig. 3 shows the first optical element LS1 as viewed from a side of the upper surface thereof.

The first liquid supply device 11 of the first liquid immersion mechanism 1 supplies the liquid LQ in order to fill, with the liquid LQ, the object plane-side space K1 between the first optical element LS1 and the second optical element LS2. The first liquid supply device 11 is provided with, for example, a tank accommodating the liquid LQ, a pressurizing pump, a temperature regulation device regulating the temperature of the liquid LQ to be supplied, a degassing device reducing a gas component in the liquid LQ to be supplied, and a filter unit removing any foreign matter from the liquid LQ. Fig. 2 shows the degassing device 18 by way of example. One end of a supply tube 13 is connected to the first liquid supply device 11. The other end of the supply tube 13 is connected to a supply member 15 via a supply flow passage 14. The liquid supply operation of the first liquid supply device 11 is controlled by the controller CONT. It is not necessarily indispensable that the exposure apparatus EX is provided with, for example, all of the tank, the pressurizing pump, the temperature regulation device, the degassing device, the filter unit and the like of the first liquid supply device 11. Instead, it is also allowable to substitutively use any equipment of the factory or the like in which the exposure apparatus EX is installed.

The first liquid recovery device 21 of the first liquid immersion mechanism 1 recovers the liquid LQ filled in the object plane-side space K1. The first liquid recovery device 21 is provided with, for example, a vacuum system (suction device) such as a vacuum pump, a gas/liquid separator separating the gas from the recovered liquid LQ, and a tank accommodating the recovered liquid LQ. One end of a recovery tube 23 is connected to the first liquid recovery device 21. The other end of the recovery tube 23 is connected to a recovery member 25 via a recovery flow passage 24. The liquid recovery operation of the first liquid recovery device 21 is controlled by the controller CONT. It is not necessarily indispensable that the exposure apparatus EX is provided with, for example, all of the vacuum system, the gas/liquid separator, the tank and the like of the first liquid recovery device 21. Instead, it is also allowable to substitutively use any equipment of the factory or the like in which the exposure apparatus EX is installed.

The other end of the supply tube 13 is connected to one end of the supply flow passage 14 formed in the barrel PK. On the other hand, the other end of the supply flow passage 14 of the barrel PK is connected to the supply member 15 arranged at the inside of (in the internal space of) the barrel PK. The supply member 15, which is arranged at the inside of the barrel PK, has the supply port 12 through which the liquid LQ is supplied to the object plane-side space K1. A supply flow passage 16, through which the liquid LQ flows, is formed in the supply member 15.

It is not necessarily indispensable that the supply flow passage 14 is formed in the barrel PK. A hole, which is communicated with the internal space and the external space of the barrel PK, may be provided for the barrel PK, and a tube member, which forms the supply flow passage 14, may be arranged in the hole of the barrel PK to be connected to the supply tube 13 and the supply member 15.

The other end of the recovery tube 23 is connected to one end of the recovery flow passage 24 formed in the barrel PK. On the other hand, the other end of the recovery flow passage 24 of the barrel PK is connected to the recovery member 25 arranged at the inside of (in the internal space of) the barrel PK. The recovery member 25, which is arranged at the inside of the barrel PK, has the recovery ports 22 through which the liquid LQ in the object plane-side space K1 is recovered. The recovery flow passage 26, through which the liquid LQ flows, is formed in the recovery member 25.

It is not necessarily indispensable that the recovery flow passage 24 is formed in the barrel PK. A hole, which is communicated with the internal space and the external space of the barrel PK, may be provided for the barrel PK; and a tube member, which forms the recovery flow passage 24, may be arranged in the hole of the barrel PK to be connected to the recovery tube 23 and the recovery member 25.

The supply member 15 is constructed of a tubular member which extends linearly in the horizontal direction. In this embodiment, the supply member 15 is arranged on the +X side of the object plane-side space K1, and is provided to extend in the X axis direction. The supply flow passage 16, which is formed in the supply member 15, has one end which is connected to the other end of the supply flow passage 14 formed in the barrel PK. The other end of the supply flow passage 16 is connected to the supply port 12. The supply port 12 is formed so that the supply port 12 is directed or oriented toward the -X side. The supply port 12 supplies the liquid LQ substantially in parallel to the upper surface of the first optical element LS1, i.e., substantially in parallel to the XY plane (in the lateral direction).

A part of the supply member 15 is provided between the upper surface of the first optical element LS1 and the lower surface of the second optical element LS2. A gap of 1 to 5 mm (1 mm in this embodiment) is formed between the upper surface of the first optical element LS1 and the lower surface of the second optical element LS2. The part of the supply member 15 is supported by the barrel PK or a predetermined support mechanism while making no contact with each of the first optical element LS1 and the second optical element LS2. When the supply member 15 makes no contact with each of the first optical element LS1 and the second optical element LS2, it is possible to suppress the change in the shapes of the first optical element LS1 and the second optical element LS2; and it is possible to maintain the high imaging performance of the projection optical system PL. The supply member 15 is provided at a position at which the radiation of the exposure light beam EL is not disturbed, i.e., outside the predetermined area AR1 through which the exposure light beam EL is allowed to pass.

The recovery member 25 is provided with a linear portion 25A and an annular portion 25B connected to the linear portion 25A. The linear portion 25A is provided to extend in the horizontal direction. In this embodiment, the linear portion 25A is arranged on the -X side in relation to the object plane-side space K1, and it is provided to extend in the X axis direction. The annular portion 25B is formed to be smaller than the edge portion of the upper surface of the first optical element LS1. A part of the annular portion 25B on the -X side is connected to the linear portion 25A. On the other hand, a part of the annular portion 25B on the +X side is open to be an opening 25K, and the supply member 15 is arranged in the opening 25K.

The recovery flow passage 26, which is adapted to the shape of the recovery member 25, is formed in the recovery member 25. The recovery flow passage 26, which is formed in the linear portion 25A of the recovery member 25, has one end which is connected to the other end of the recovery flow passage 24 formed in the barrel PK. The recovery flow passage 26 is formed annularly in the annular portion 25B of the recovery member 25 to surround the object plane-side space K1. The recovery flow passage 26, which is formed in the linear portion 25A, has the other end which is connected to a part of the annular recovery flow passage 26 formed in the annular portion 25B.

The recovery port 22 is formed on the inner side surface of the annular portion 25B directed to the object plane-side space K1. The recovery port 22 recovers the liquid LQ in the object plane-side space K1. The recovery port 22 is provided as a plurality of recovery ports 22 on the inner side surface of the annular portion 25B to surround the object plane-side liquid immersion area LR1 to be formed on the upper surface of the first optical element LS1. Each of the plurality of recovery ports 22, which are formed on the inner side surface of the annular portion 25B, is connected to the recovery flow passage 26 formed in the annular portion 25B.

The recovery member 25 (annular portion 25B) is provided at the position at which the radiation of the exposure light beam EL is not disturbed. That is, the recovery member 25 (annular portion 25B) is provided to surround the predetermined area AR1 through which the exposure light beam EL is allowed to pass.

A part of the recovery member 25 is provided between the upper surface of the first optical element LS1 and the lower surface of the second optical element LS2. That is, the recovery member 25 is supported by the barrel PK or a predetermined support mechanism while making no contact with each of the first optical element LS1 and the second optical element LS2. Accordingly, it is possible to suppress the change in the shapes of the first optical element LS1 and the second optical element LS2, and it is possible to maintain the high imaging performance of the projection optical system PL.

When the liquid LQ is supplied to the object plane-side space K1 in order to form the object plane-side liquid immersion area LR1, the controller CONT drives the first liquid supply device 11. When the liquid LQ is fed from the first liquid supply device 11 under the control of the controller CONT, the liquid LQ, which is fed from the first liquid supply device 11, is supplied to the object plane-side space K1 via the supply tube 13, the supply flow passage 14 formed in the barrel PK, the supply member 15, and the supply port 12. The liquid LQ, which is supplied from the supply port 12, locally forms the object plane-side liquid immersion area LR1 in a partial area of the upper surface of the first optical element LS1, the area being larger than the predetermined area AR1 through which the exposure light beam EL passes and being smaller than the upper surface the first optical element LS1. The liquid LQ, which is supplied between the first optical element LS1 and the second optical element LS2, is retained by the surface tension between the upper surface of the first optical element LS1 and the lower surface of the second optical element LS2. The liquid LQ, filled in the object plane-side space K1, makes contact with a partial area of the upper surface of the first optical element LS1 and the liquid LQ makes contact with the substantially entire area of the lower surface of the second optical element LS2. In this embodiment, the outer diameter of the lower surface of the second optical element LS2 is smaller than the outer diameter of the upper surface of the first optical element LS1. Therefore, the liquid LQ, filled in the space between the first optical element LS1 and the second optical element LS2, can form the object plane-side liquid immersion area LR1 under or below the lower surface of the second optical element LS2, the object plane-side liquid immersion area LR1 being smaller than the upper surface of the first optical element LS1.

When the liquid LQ of the object plane-side space K1 is recovered, the controller CONT drives the first liquid recovery device 21 of the first liquid immersion mechanism 1. When the first liquid recovery device 21 having the vacuum system is driven, the liquid LQ of the object plane-side space K1 is allowed to flow into the recovery flow passage 26 formed in the annular portion 25B of the recovery member 25 via the recovery ports 22. The recovery ports 22 are arranged to surround the object plane-side space K1. Therefore, the liquid LQ of the object plane-side space K1 is recovered via the recovery ports 22 from the circumference thereof. The liquid LQ, which inflows into the recovery flow passage 26 formed in the annular portion 25B, is collected at the recovery flow passage 26 formed in the linear portion 25A. After that, the liquid LQ inflows into the recovery flow passage 24 formed in the barrel PK. The liquid LQ, which is allowed to flow through the recovery flow passage 24, is sucked and recovered via the recovery tube 23 by the second liquid recovery device 21.

Next, the second liquid immersion mechanism 2 will be explained. The second liquid supply device 31 of the second liquid immersion mechanism 2 supplies the liquid LQ in order to fill, with the liquid LQ, the image plane-side space K2 on the light-exit side of the first optical element LS1. The second liquid supply device 31 has a construction which is approximately equivalent to that of the first liquid supply device 11. That is, the second liquid supply device 31 is provided with, for example, a tank accommodating the liquid LQ, a pressurizing pump, a temperature regulation device regulating the temperature of the liquid LQ to be supplied, a degassing device reducing gas component in the liquid LQ to be supplied, and a filter unit removing any foreign matter from the liquid LQ. Fig. 2 shows the degassing device 38 by way of example. One end of the supply tube 33 is connected to the second liquid supply device 31. The other end of the supply tube 33 is connected to the nozzle member 70. The liquid supply operation of the second liquid supply device 31 is controlled by the controller CONT. It is not necessarily indispensable that that the exposure apparatus EX is provided with, for example, all of the tank, the pressurizing pump, the temperature regulation device, the degassing device, and the filter unit of the second liquid supply device 31. Instead, it is also allowable to substitutively use any equipment of the factory or the like in which the exposure apparatus EX is installed.

The second liquid recovery device 41 of the second liquid immersion mechanism 2 recovers the liquid LQ filled in the image plane-side space K2. The second liquid recovery device 41 has a construction which is approximately equivalent to that of the first liquid recovery device 21. That is, the second liquid recovery device 41 is provided with, for example, a vacuum system such as a vacuum pump, a gas/liquid separator separating the gas from the recovered liquid LQ, and a tank accommodating the recovered liquid LQ. One end of the recovery tube 43 is connected to the second liquid recovery device 41. The other end of the recovery tube 43 is connected to the nozzle member 70. The liquid recovery operation of the second liquid recovery device 41 is controlled by the controller CONT. It is not necessarily indispensable that the exposure apparatus EX is provided with, for example, all of the vacuum system, the gas/liquid separator, and the tank of the second liquid recovery device 41. Instead, it is also allowable to substitutively use any equipment of the factory or the like in which the exposure apparatus EX is installed.

The supply port 32 supplying the liquid LQ to the image plane-side space K2 and the recovery port 42 recovering the liquid LQ from the image plane-side space K2 are formed on the lower surface of the nozzle member 70. The lower surface of the nozzle member 70 is provided at a position opposite to or facing at least parts of the surface of the substrate P, the upper surface F1 of the substrate stage ST1, and the upper surface F2 of the measuring stage ST2. The nozzle member 70 is an annular member which is provided to surround the side surface of the barrel PK in the vicinity of the image plane-side of the projection optical system PL. The supply port 32 is provided as a plurality of supply ports 32 to surround the image plane-side space K2 on the lower surface of the nozzle member 70. The recovery port 42 is provided at the outside of the supply ports 32 with respect to the image plane-side space K2 on the lower surface of the nozzle member 70. The recovery port 42 is provided in an annular form to surround the image plane-side space K2 and the supply ports 32. A porous member is provided for the recovery port 42 of this embodiment. The porous member is formed of, for example, a porous material made of ceramics or a plate-shaped mesh made of titanium.

The controller CONT fills the image plane-side space K2 with the liquid LQ by supplying a predetermined amount of the liquid LQ from the second liquid supply device 31 of the second liquid immersion mechanism 2 and by recovering a predetermined amount of the liquid LQ by using the second liquid recovery device 41 of the second liquid immersion mechanism 2 to locally form the image plane-side liquid immersion area LR2 of the liquid LQ on the object arranged at the position opposite to or facing the projection optical system PL, i.e., on the upper surface of at least a part of the substrate P, the substrate stage ST1, and the measuring stage ST2. When the image plane-side liquid immersion area LR2 is formed, the controller CONT drives each of the second liquid supply device 31 and the second liquid recovery device 41 of the second liquid immersion mechanism 2. When the liquid LQ is fed from the second liquid supply device 31 under the control of the controller CONT, then the liquid LQ, which is fed from the second liquid supply device 31, is allowed to flow through the supply tube 33, and then the liquid LQ is supplied from the supply ports 32 to the image plane-side space K2 via a supply flow passage formed in the nozzle member 70. When the second liquid recovery device 41 is driven under the control of the controller CONT, then the liquid LQ in the image plane-side space K2 is allowed to inflow into a recovery flow passage formed in the nozzle member 70, the liquid LQ is allowed to flow through the recovery tube 43, and then the liquid LQ is recovered by the second liquid recovery device 41.

The reflection loss is reduced on the lower surface of the second optical element LS2 and the upper surface of the first optical element LS1 by filling, with the liquid LQ, the object plane-side space K1 and the image plane-side space K2 by using the first liquid immersion mechanism 1 and the second liquid immersion mechanism 2, respectively; and the substrate P can be exposed satisfactorily in a state in which a large numerical aperture on the image side is secured.

For example, a degassing device using a hollow fiber membrane may be used as the degassing device 18 of the first liquid supply device 11, as disclosed, for example, in International Publication No. 2004/053950. In this embodiment, the first liquid supply device 11 is operated such that the dissolved gas concentration (for example, the dissolved oxygen concentration) of the liquid LQ to be supplied to the object plane-side space K1 is not more than 5 ppm by using the degassing device 18.

The degassing device 38, which is provided for the second liquid supply device 31, also has a construction approximately equivalent to that of the degassing device 18 of the first liquid supply device 11. The second liquid supply device 31 is also operated such that the dissolved gas concentration (for example, the dissolved oxygen concentration) of the liquid LQ to be supplied to the image plane-side space K2 is not more than 5 ppm by using the degassing device 38.

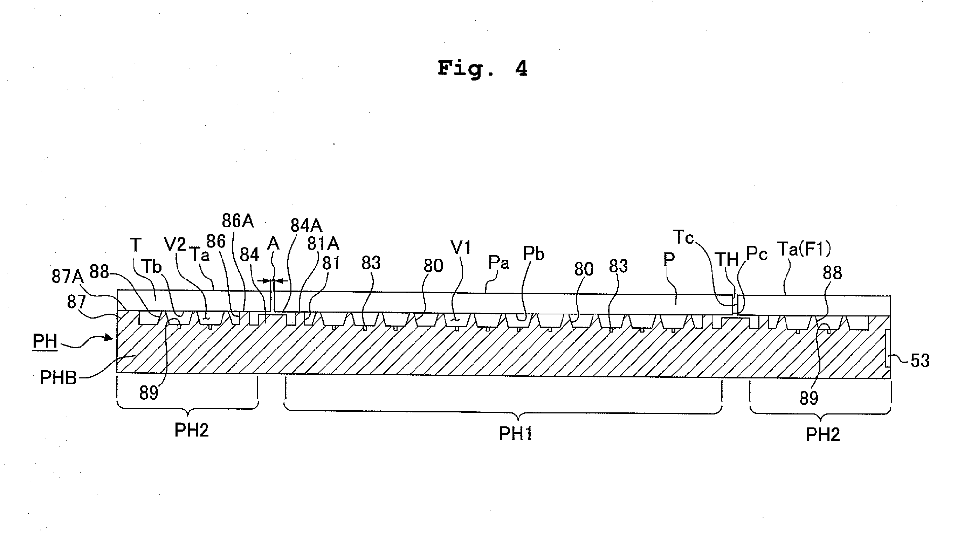

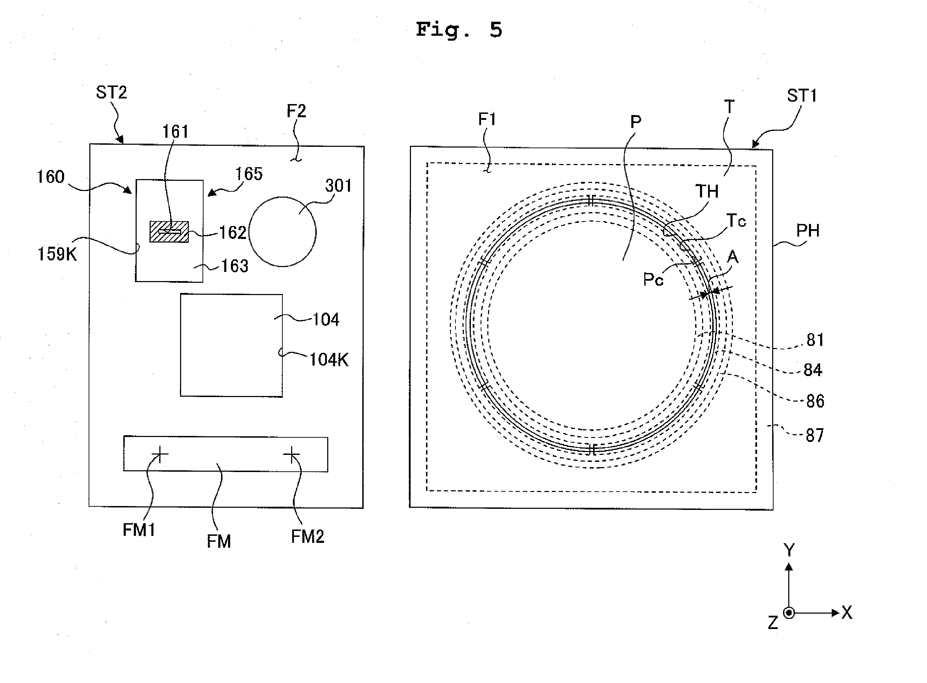

Next, the substrate holder PH will be explained with reference to Figs. 4 and 5. Fig. 4 shows a side sectional view illustrating the substrate holder PH. Fig. 5 shows a plan view illustrating the substrate stage PH (substrate stage ST1) and the measuring stage ST2 as viewed from a position thereabove.

With reference to Fig. 4, the substrate holder PH is provided with a base member PHB, a first holding portion PH1 which is formed in the base member PHB and which detachably attracts and holds the substrate P, and a second holding portion PH2 which is formed in the base member PHB and which attracts and holds a plate member T around the substrate P held by the first holding member PH1. The plate member T is a member which is distinct or different from the base member PHB. The plate member T is provided detachably (exchangeably) with respect to the base member PHB of the substrate holder PH. As shown in Fig. 5, a substantially circular hole TH, in which the substrate P is can be arranged, is formed at a central portion of the plate member T. The plate member T, which is held by the second holding portion PH2, is arranged to surround the circumference of the substrate P held by the first holding portion PH1. A gap A of about 0.1 to 1.0 mm is formed between an outer edge (side surface) Pc of the substrate P which is held by the first holding portion PH1 and an inner (on the side of the hole TH) edge (inner side surface) Tc of the plate member T which is arranged at the outside of the substrate P and which is held by the second holding portion PH2. The outer shape of the plate member T is formed to be rectangular as viewed in a plan view. In this embodiment, the outer shape of the plate member T is formed to have a size approximately same as that of the outer shape of the base member PHB.

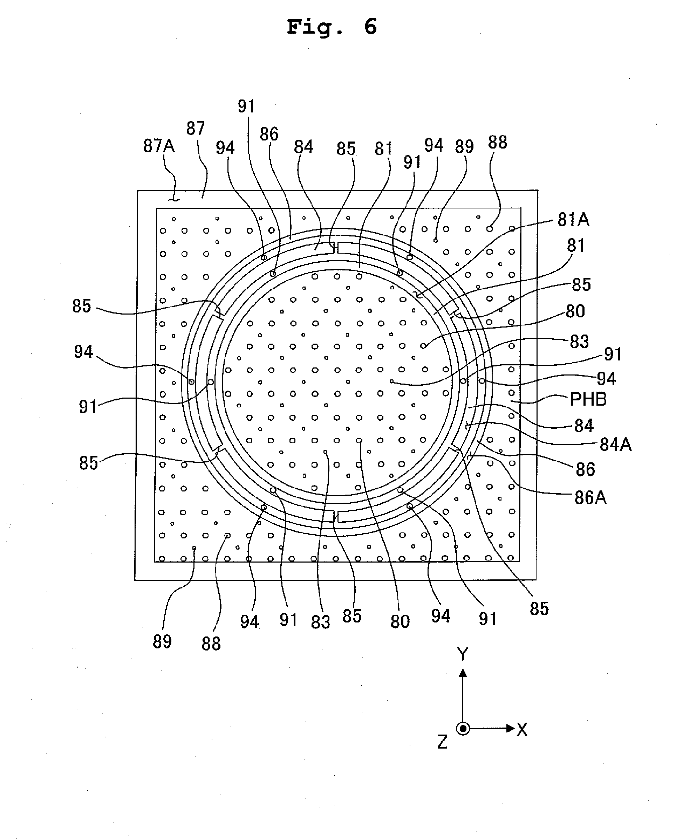

Fig. 6 shows a state in which the substrate P and the plate member T are detached from the first and second holding portions PH1, PH2 respectively.

The plate member T is liquid-repellent with respect to the liquid LQ. Specifically, the contact angle of the liquid LQ, which is obtained when the liquid LQ is arranged on an upper surface Ta of the plate member T, is not less than 90°. The plate member T is formed of a liquid-repellent material including, for example, acrylic resin and fluorine-based resin such as polytetrafluoroethylene (Teflon (trade name)). The plate member T may be formed of, for example, a metal, and its surface may be coated with a liquid-repellent material such as fluorine-based resin.

With reference to Fig. 4, the upper surface Ta and a lower surface Tb of the plate member T are substantially flat surfaces (flat portions) respectively. The upper surface Ta of the plate member T held by the second holding portion PH2 is substantially flush with an upper surface Pa of the substrate P held by the first holding portion PH1. Accordingly, the image plane-side liquid immersion area LR2 can be smoothly moved between the upper surface Pa of the substrate P and the upper surface Ta of the plate member T while filling, with the liquid LQ, the image plane-side space K2 of the projection optical system PL by moving the substrate holder PH (substrate stage ST1) in the XY directions with respect to the projection optical system PL while supplying and recovering the liquid LQ by the second liquid immersion mechanism 2. It is also allowable that any difference in height exists between the upper surface Pa of the substrate P held by the first holding portion PH1 and the upper surface Ta of the plate member T held by the second holding portion PH2 provided that the image plane-side space K2 of the projection optical system PL can be continuously filled with the liquid LQ.

With reference to Figs. 4, 5, and 6, the first holding portion PH1 of the substrate holder PH is provided with a plurality of first protrusions 80 which are formed on the base member PHB, and an annular first circumferential wall portion 81 which is formed on the base member PHB to surround the circumference of the plurality of first protrusions 80. The first protrusions 80 support the lower surface Pb of the substrate P. The first circumferential wall portion 81 is formed to have a substantially annular shape as viewed in a plan view corresponding to the shape of the substrate P. An upper surface 81A of the first circumferential wall portion 81 is formed to be opposite to the circumferential edge area (edge area) of the lower surface Pb of the substrate P. A first space V1, which is surrounded by the base member PHB, the first circumferential wall portion 81, and the lower surface Pb of the substrate P, is formed on the side of the lower surface Pb of the substrate P held by the first holding portion PH1.

A first suction port 83 is formed on the base member PHB at a portion thereof located inside the first circumferential wall portion 81. The first suction port 83 is provided as a plurality of first suction ports 83 at a plurality of predetermined positions which are different from positions of the first protrusions 80 on the upper surface of the base member PHB and which are located at the inside of the first circumferential wall portion 81 respectively in order to attract and hold the substrate P. Each of the first suction ports 83 is connected to an unillustrated first vacuum system. The controller CONT is operated such that the substrate P is attracted and held by the first protrusions 80 by driving the first vacuum system so that the first space V1 has the negative pressure by sucking the gas (air) in the first space V1 surrounded by the base member PHB, the first circumferential wall portion 81, and the substrate P; and that the substrate P can be detached from the first holding portion PH1 by stopping or releasing the suction operation having been performed by the first vacuum system. In this embodiment, the first holding portion PH1 constructs a so-called pin chuck mechanism.

A second circumferential wall portion 84 is provided at the outside of the first circumferential wall portion 81. In this embodiment, an upper surface 84A of the second circumferential wall portion 84 is formed to have a large (wide) width. Slits 85 are provided at a plurality of predetermined positions respectively in the circumferential direction of the second circumferential wall portion 84.

The second holding portion PH2 of the substrate holder PH is provided with a substantially annular third circumferential wall portion 86 which is formed on the base member PHB to surround the second circumferential wall portion 84, an annular (frame-shaped) fourth circumferential wall portion 87 which is provided at the outside of the third circumferential wall portion 86 and which is formed on the base member PHB to surround the third circumferential wall portion 86, and a plurality of second protrusions 88 which are formed on the base member PHB at a portion thereof between the third circumferential wall portion 86 and the fourth circumferential wall portion 87. The second protrusions 88 support the lower surface Tb of the plate member T. The third circumferential wall portion 86 is formed to have a substantially annular shape as viewed in a plan view corresponding to the shape of the hole TH of the plate member T. The fourth circumferential wall portion 87 is formed to have a substantially rectangular annular shape as viewed in a plan view corresponding to the outer shape of the plate member T. An upper surface 86A of the third circumferential wall portion 86 is formed to be opposite to the inner edge area (edge area at the inside), of the lower surface Tb of the plate member T, disposed in the vicinity of the hole TH. An upper surface 87A of the fourth circumferential wall portion 87 is formed to be opposite to the outer edge area (edge area at the outside) of the lower surface Tb of the plate member T. A second space V2, which is surrounded by the base member PHB, the third and fourth circumferential wall portions 86, 87, and the lower surface Tb of the plate member T, is formed on the side of the lower surface Tb of the plate member T held by the second holding portion PH2.

A Second suction port 89 is formed on the base member PHB at a portion thereof located between the third circumferential wall portion 86 and the fourth circumferential wall portion 87. The second suction port 89 is provided as a plurality of second suction ports 89 at a plurality of predetermined positions, which are different from positions of the second protrusions 88, on the upper surface of the base member PHB at a portion thereof between the third circumferential wall portion 86 and the fourth circumferential wall portion 87 respectively in order to attract and hold the plate member T. Each of the second suction ports 89 is connected to an unillustrated second vacuum system. The controller CONT is operated such that the plate member T can be attracted and held by the second protrusions 88 by driving the second vacuum system so that the second space V2 has the negative pressure by sucking the gas (air) in the second space V2 surrounded by the base member PHB, the third and fourth circumferential wall portions 86, 87, and the plate member T; and that the plate member T can be detached from the second holding portion PH2 by stopping or releasing the suction operation having been performed by the second vacuum system. In this embodiment, the second holding portion PH2 also constructs a so-called pin chuck mechanism.

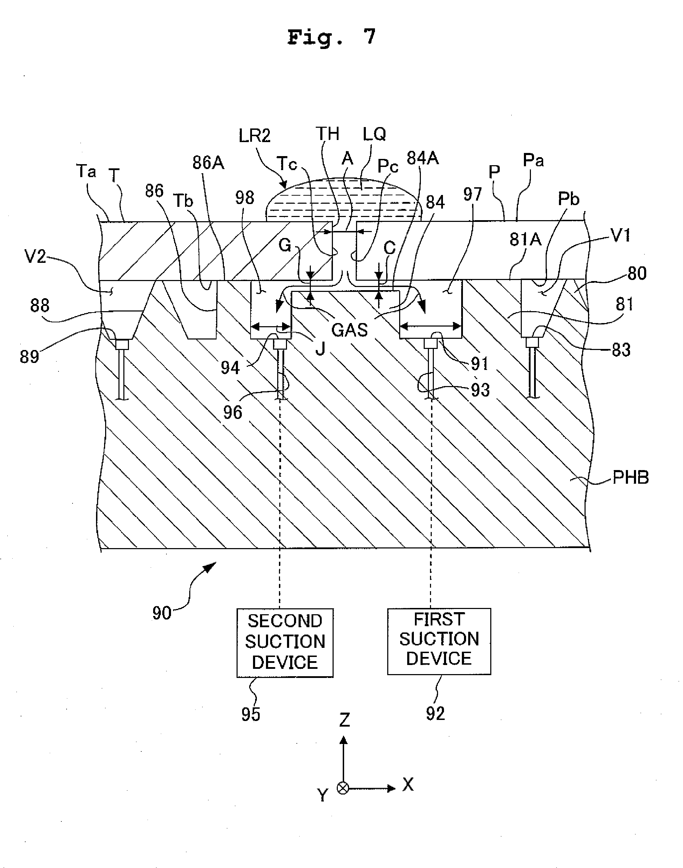

Fig. 7 shows those disposed in the vicinity of the gap A. In this embodiment, the gap A is set to be about 0.1 to 1.0 mm to suppress the inflow of the liquid LQ into the substrate holder PH via the gap A. However, as shown in Fig. 7, there is such a possibility that the liquid LQ inflows into the substrate holder PH via the gap A, for example, when the image plane-side liquid immersion area LR2 is formed on the gap A. In this embodiment, the exposure apparatus EX is provided with a liquid recovery mechanism 90 which recovers the liquid LQ inflowed via the gap A.

The liquid recovery mechanism 90 is provided with a first recovery port 91 which is provided between the first circumferential wall portion 81 and the second circumferential wall portion 84, a first suction device 92 which includes a vacuum system connected to the first recovery port 91 via a flow passage 93, a second recovery port 94 which is provided between the second circumferential wall portion 84 and the third circumferential wall portion 86, and a second suction device 95 which includes a vacuum system connected to the second recovery port 94 via a flow passage 96. The first recovery port 91 is provided on the upper surface of the base member PHB at a portion thereof between the outer side surface of the first circumferential wall portion 81 and the inner side surface of the second circumferential wall portion 84. The second recovery port 94 is provided on the upper surface of the base member PHB at a portion thereof between the outer side surface of the second circumferential wall portion 84 and the inner side surface of the third circumferential wall portion 86.

The first suction device 92 and the first vacuum system for providing the negative pressure in the first space V1 are independent from each other. Further, the second suction device 95 and the second vacuum system for providing the negative pressure in the second space V2 are independent from each other. The controller CONT can individually control the respective operations of the first and second suction devices 92, 95 and the first and second vacuum systems. It is possible to independently perform the suction operations by the first and second suction devices 92, 95 and the suction operations by the first and second vacuum systems respectively.

As shown in Fig. 7, the lower surface Pb of the substrate P held by the first holding portion PH1 is opposite to a partial area of the upper surface 84A of the second circumferential wall portion 84. Further, the lower surface Tb of the plate member T held by the second holding portion PH2 is opposite to the other area of the upper surface 84A of the second circumferential wall portion 84. That is, the upper surface 84A of the second circumferential wall portion 84 is arranged just under or below the gap A formed between the substrate P and the plate member T. A predetermined gap C is formed between the lower surface Pb of the substrate P and the upper surface 84A of the second circumferential wall portion 84. Further, a predetermined gap G is formed between the lower surface Tb of the plate member T and the upper surface 84A of the second circumferential wall portion 84.

The gap C forms a flow passage which communicates a third space 97 formed by the base member PHB, the first circumferential wall portion 81, the second circumferential wall portion 84, and the lower surface Pb of the substrate P and the space disposed at the outside of the third space 97.

The gap G forms a flow passage which communicates a fourth space 98 formed by the base member PHB, the second circumferential wall portion 84, the third circumferential wall portion 86, and the lower surface Tb of the plate member T and a space disposed at the outside of the fourth space 98.

As shown in Fig. 6, the first recovery port 91 is provided as a plurality of first recovery ports 91 at a plurality of predetermined positions along the first circumferential wall portion 81 and at the outside of the first circumferential wall portion 81 respectively. In this embodiment, the respective first recovery ports 81 are substantially circular as viewed in a plan view, and are provided at predetermined intervals at six positions in the circumferential direction of the first circumferential wall portion 81 on the upper surface of the base member PHB. The slits 85 of the second circumferential wall portion 84 are provided such that the each of the slits 85 is located between mutually adjacent first recovery ports 91 among the plurality of first recovery ports 91.

The second recovery port 94 is provided as a plurality of second recovery ports 94 at a plurality of predetermined positions along the second circumferential wall portion 84 and at the outside of the second circumferential wall portion 84 respectively. In this embodiment, the respective second recovery ports 94 are substantially circular as viewed in a plan view, and are provided at predetermined intervals at the six positions in the circumferential direction of the second circumferential wall portion 84 on the upper surface of the base member PHB. The second recovery ports 94 are provided such that each of the second recovery ports 94 is located between mutually adjacent slits 85 among the plurality of slits 85 of the second circumferential wall portion 84.

The liquid LQ, which inflows into at least one of the third space 97 and the fourth space 98 via the gap A, can be recovered by driving at least one of the first suction device 92 and the second suction device 95.

For example, when the first suction device 92 is driven, the flow of the gas, which is directed to the first recovery port 91 along the first and second circumferential wall portions 81, 84, is generated in the vicinity of the first recovery ports 91 (third space 97). Therefore, the liquid LQ, which inflows into the third space 97, can be moved to the first recovery ports 91 by the flow of the gas, and the liquid LQ can be recovered via the first recovery ports 91.

Further, the flow of the gas, which is directed from the outside to the inside of the third space 97, is also generated in the gap C. Therefore, the liquid LQ, which stays or remains in the gap C, is attracted and pulled into the third space 97 by the flow of the gas. The liquid LQ is smoothly moved to the first recovery ports 91, and the liquid LQ is recovered.

On the other hand, when the second suction device 95 is driven, the flow of the gas, which is directed to the second recovery ports 94 along the second and third circumferential wall portions 84, 86, is generated in the vicinity of the second recovery ports 94 (fourth space 98). Therefore, the liquid LQ, which inflows into the fourth space 98, can be moved to the second recovery ports 94 by the flow of the gas, and the liquid LQ can be recovered via the second recovery ports 94.

Further, the flow of the gas, which is directed from the outside to the inside of the fourth space 98, is also generated in the gap G. Therefore, the liquid LQ, which stays or remains in the gap G, is attracted and pulled into the fourth space 98 by the flow of the gas. The liquid LQ is smoothly moved to the second recovery ports 94, and the liquid LQ is recovered.

When a gap B between the first circumferential wall portion 81 and the second circumferential wall portion 84 is defined to be, for example, about 0.5 to 1.5 mm, the flow velocity of the flow of the gas directed to the first recovery ports 91 can be enhanced in the groove-shaped third space 97. Similarly, when a gap J between the second circumferential wall portion 84 and the third circumferential wall portion 86 is defined to be, for example, about 0.5 to 1.5 mm, the flow of the gas directed to the second recovery ports 94 can be enhanced in the groove-shaped fourth space 98.

In this embodiment, the recovery operation for recovering the liquid LQ, which uses the first recovery ports 91 and the second recovery ports 94, is stopped during the exposure for the substrate P. The recovery operation for recovering the liquid LQ is executed when the exposure for the substrate P is not performed. After the completion of the exposure for the substrate P, when the liquid LQ, which inflows via the gap A, is recovered, the controller CONT can drive the first suction device 92 and the second suction device 95 respectively to concurrently perform the recovery operation for recovering the liquid LQ using the first recovery ports 91 and the recovery operation for recovering the liquid LQ using the second recovery ports 94.

In this embodiment, the gap C, the gap G, the suction force with the first recovery ports 91, and the suction force with the second recovery ports 94 are defined so that the suction force for the liquid LQ to be sucked into the gap G is larger than the suction force for the liquid LQ to be sucked into the gap C. Therefore, the liquid LQ, which inflows from the gap A, can be smoothly attracted and pulled into the side of the lower surface Tb of the plate member T. Therefore, it is possible to avoid any inconvenience or problem which would be otherwise caused such that the liquid LQ, which inflows from the gap A, flows from the upper surface of the substrate P and arrives at the side of the lower surface Pb of the substrate P.

The liquid recovery mechanism 90 not only recovers the liquid LQ inflowed into the gap A, but the liquid recovery mechanism 90 is also capable of actively recovering, via the gap A, the liquid LQ in the image plane-side liquid immersion area LR2 formed on the gap A, for example, when all of the liquid LQ in the image plane-side liquid immersion area LR2 is fully recovered. When it is intended to fully recover all of the liquid LQ in the image plane-side liquid immersion area LR2, the controller CONT can simultaneously employ both of the recovery operation using the second liquid recovery device 41 of the second liquid immersion mechanism 2 and the recovery operation using the liquid recovery mechanism 90.

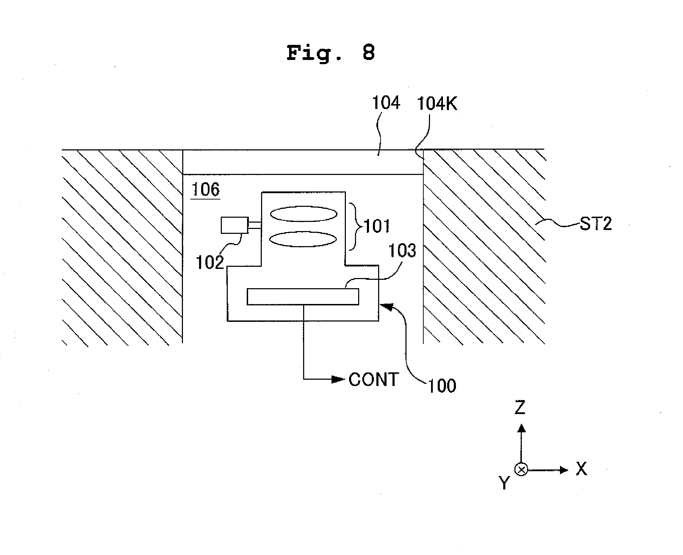

Next, the measuring stage ST2 will be explained with reference to Figs. 5 and 8. Fig. 8 shows a sectional view schematically illustrating a part of the measuring stage ST2. As described above, various types of measuring devices (including a measuring member) are provided on the measuring stage ST2 in order to perform the measurement in relation to the exposure process. The measuring devices provided on the measuring stage ST2 include, for example, a reference mark plate formed with a plurality of reference marks as disclosed, for example, in Japanese Patent Application Laid-open No. 5-21314, an unevenness sensor for measuring the uneven illuminance as disclosed, for example, in Japanese Patent Application Laid-open No. 57-117238 or for measuring the fluctuation amount of the transmittance for the exposure light beam EL of the projection optical system PL as disclosed in Japanese Patent Application Laid-open No. 2001-267239, a spatial image-measuring sensor as disclosed in Japanese Patent Application Laid-open Nos. 2002-14005 and 2002-198303, and a radiation amount sensor (illuminance sensor) as disclosed in Japanese Patent Application Laid-open No. 11-16816. Other than the above, the measuring devices provided on the measuring stage ST2 also include, for example, a wavefront aberration-measuring device disclosed, for example, in International Publication No. 99/60361 (corresponding to United States Patent Application No. 09/714,183), Japanese Patent Application Laid-open No. 2002-71514, and United States Patent No. 6,650,399, and a reflecting portion disclosed, for example, in Japanese Patent Application Laid-open No. 62-183522. As described above, the measuring stage ST2 is an exclusive stage for performing the measurement process in relation to the exposure process. The measuring stage ST2 is constructed such that the substrate P is not held thereon. The substrate stage ST1 is constructed such that any measuring device to perform the measurement in relation to the exposure process is not provided thereon. The exposure apparatus, which is provided with the measuring stage as described above, is disclosed in detail, for example, in Japanese Patent Application Laid-open Nos. 11-135400 and 2000-164504 (United States Patent No. 6,897,963 corresponding thereto); contents of United States Patent No. 6,897,963 are incorporated herein by reference.

It is not necessarily indispensable that all of the measuring devices as described above are provided on the measuring stage ST2. If necessary, it is also allowable that a part or parts of the measuring devices are provided. Some of the measuring devices required for the exposure apparatus EX may be provided on the measuring stage ST2, and the remaining of the measuring devices may be provided on the substrate stage ST1.

In this embodiment, the measuring stage ST2 is provided with an observing device 100 which is capable of observing the state of each of the object plane-side liquid immersion area LR1 and the image plane-side liquid immersion area LR2. The observing device 100 is provided inside the measuring stage ST2.

As shown in Fig. 8, an opening 104K is formed on the measuring stage ST2. A transparent member 104 is arranged in the opening 104K. The transparent member 104 is formed of, for example, a glass plate. The upper surface of the transparent member 104 is a flat surface.

An internal space 106, which is connected to the opening 104, is formed in the measuring stage ST2. The observing device 100 is arranged in the internal space 106 of the measuring stage ST2. The observing device 100 is provided with an optical system 101 which is arranged under or below the transparent member 104, and an image pickup element 103 which is constructed of, for example, CCD. The image pickup element 103 is capable of obtaining the optical image (image) of the liquid LQ for forming the first liquid immersion area LR1 and the second liquid immersion area LR2 via the transparent member 104 and the optical system 101. The image pickup element 103 converts the obtained image into an electric signal. The signal (image information) is outputted to the controller CONT. The observing device 100 has an adjusting mechanism 102 which is capable of adjusting the focus position of the optical system 101. The observing device 100 has a field capable of observing the whole of the object plane-side liquid immersion area LR1 and the whole of the image plane-side liquid immersion area LR2.

All of the observing device 100 may be arranged in the measuring stage ST2. However, for example, a part or parts of a plurality of optical elements constructing the optical system 101 and the image pickup element 103 may be arranged at the outside of the measuring stage ST2. It is also allowable to adopt an arrangement in which the adjusting mechanism 102 is omitted.

As shown in Fig. 5, the reference mark plate FM described above is arranged on the measuring stage ST2. A reference mark (first reference mark) FM1 to be detected by the alignment system RA and a reference mark (second reference mark) FM2 to be detected by the alignment system ALG are formed in a predetermined positional relationship on the reference mark plate FM. The reference mark plate FM is used in order that the alignment position of the substrate P is defined with respect to the pattern image of the mask M formed via the projection optical system PL, and that the positional relationship (base line amount) in the XY plane is measured between the projection position of the pattern image and the detection reference of the alignment system ALG.

As described above, the first reference mark FM1 on the reference mark plate FM is measured via the projection optical system PL and the liquid LQ by the mask alignment system RA. When the measurement is performed by using the reference mark plate FM, the controller CONT observes the first reference mark FM1 by the mask alignment system RA in a state in which the space between the first optical element LS1 and the reference mark plate FM (first reference member FM1) is filled with the liquid LQ when the measuring stage ST2 is opposite to the projection optical system PL (first optical element LS1).

An upper plate 165, which constitutes a part of the spatial image-measuring sensor 160, is provided on the measuring stage ST2.

The spatial image-measuring sensor 160 is used to measure the imaging characteristic (optical characteristic) of the projection optical system PL including the first optical element LS1 and the second optical element LS2 in a state in which the object plane-side space K1 and the image plane-side space K2 are filled with the liquid LQ. The spatial image-measuring sensor 160 is provided with, for example, the upper plate 165 which is arranged on the measuring stage ST2, an unillustrated light-receiving element (optical sensor) which is constructed of a photoelectric conversion element, and an unillustrated optical system which guides, to the light-receiving element, the light beam passing through the upper plate 165.

An opening 159K is formed on the measuring stage ST2. The upper plate 165 is fitted into the opening 159K. An internal space, which is connected to the opening 159K, is formed in the measuring stage ST2. The optical system and the light-receiving element, which constructs the spatial image-measuring sensor 160, are arranged in the internal space.

As shown in Fig. 5, the upper plate 165 is provided with a light-shielding film 162 which is formed of chromium or the like and is provided at a central portion of an upper surface of a glass plate member having a rectangular shape as viewed in a plan view; a reflective film 163 which is formed of aluminum or the like and is provided around the light-shielding film 162, i.e., at a portion different from than the light-shielding film 162 of the upper surface of the glass plate member; and a slit 161 which is an aperture pattern formed on a part of the light-shielding film 162. The glass plate member, which is a transparent member, is exposed at the slit 161. The light beam is transmissive through the slit 161. That is, the slit 161 functions as the light-transmitting portion formed on the upper plate 165.

When the imaging characteristic of the projection optical system PL is measured by using the spatial image-measuring sensor 160, a measuring mask, on which a pattern for measuring the spatial image, is held on the mask stage MST. The controller CONT fills the object plane-side space K1 with the liquid LQ by using the first liquid immersion mechanism 1; and the controller CONT fills, with the liquid LQ, the image plane-side space K2 between the projection optical system PL and the upper plate 165 by using the second liquid immersion mechanism 2 in a state in which the projection optical system PL and the measuring stage ST2 are opposite to each other. The second liquid immersion mechanism 2 forms the image plane-side liquid immersion area LR2 on the upper plate 165 so that the slit 161 is covered with the liquid LQ.

The controller CONT radiates the exposure light beam EL from the illumination optical system IL. The exposure light beam EL is allowed to pass through the measuring mask, the projection optical system PL, and the liquid LQ in the object plane-side liquid immersion area LR1 and the image plane-side liquid immersion area LR2, and then the exposure light beam EL is radiated onto the upper plate 165. The light beam, which is allowed to pass through the slit 161 of the upper plate 165, is guided to the unillustrated light-receiving element via the unillustrated optical system. The photoelectric conversion signal (light amount signal), which corresponds to the receiving light amount, is outputted by the light-receiving element to the controller CONT via a signal processing device. The controller CONT performs the predetermined calculation process based on the light-receiving result of the light-receiving element to determine the imaging characteristic as obtained via the projection optical system PL and the liquid LQ.

The entire spatial image-measuring sensor 160 may be arranged in the measuring stage ST2. Alternatively, for example, a part or parts of the optical system and the light-receiving element may be arranged at the outside of the measuring stage ST2. It is allowable to use a measuring pattern provided for the mask stage MST in place of the measuring mask.

Also when the predetermined measurement is performed by using the unevenness sensor described above, then the controller CONT fills the object plane-side space K1 with the liquid LQ by using the first liquid immersion mechanism 1, and the controller CONT fills, with the liquid LQ, the image plane-side space K2 between the first optical element LS1 and the upper plate 301 of the unevenness sensor arranged on the measuring stage ST2 by using the second liquid immersion mechanism 2 to receive the exposure light beam EL via the liquid LQ and the light-transmitting portion formed on the upper plate 301. Although omitted from the illustration in Fig. 5 in order to simplify the explanation, the following procedure is adopted when the predetermined measurement is performed by using any other measuring device as described above (for example, the radiation amount sensor or the wavefront aberration-measuring device) as well. That is, the controller CONT fills the object plane-side space K1 with the liquid LQ by using the first liquid immersion mechanism 1, and the controller CONT fills, with the liquid LQ, the space between the first optical element LS1 and the upper plate for constructing a part of the measuring device arranged on the measuring stage ST2 by using the second liquid immersion mechanism 2 to receive the exposure light beam EL via the liquid LQ and the light-transmitting portion formed on the upper plate.

For example, the upper surface of the transparent member 104, the upper surface of the reference mark plate FM, the upper surface of the upper plate 165 of the spatial image-measuring sensor 160, and the upper surface 301 of the unevenness sensor are substantially flush with the upper surface of the measuring stage ST2. That is, the upper surface of the measuring stage ST2 and the upper surfaces of the respective measuring members are provided so that they have heights which are approximately same (they are flush with each other). The upper surface of the measuring stage ST2 includes the upper surfaces of the respective measuring members. In the following description, the upper surface of the measuring stage ST2, which includes the upper surfaces of the respective measuring members, is appropriately referred to as "upper surface F2". It is desirable that the upper surface F2 of the measuring stage ST2 is liquid-repellent with respect to the liquid LQ.

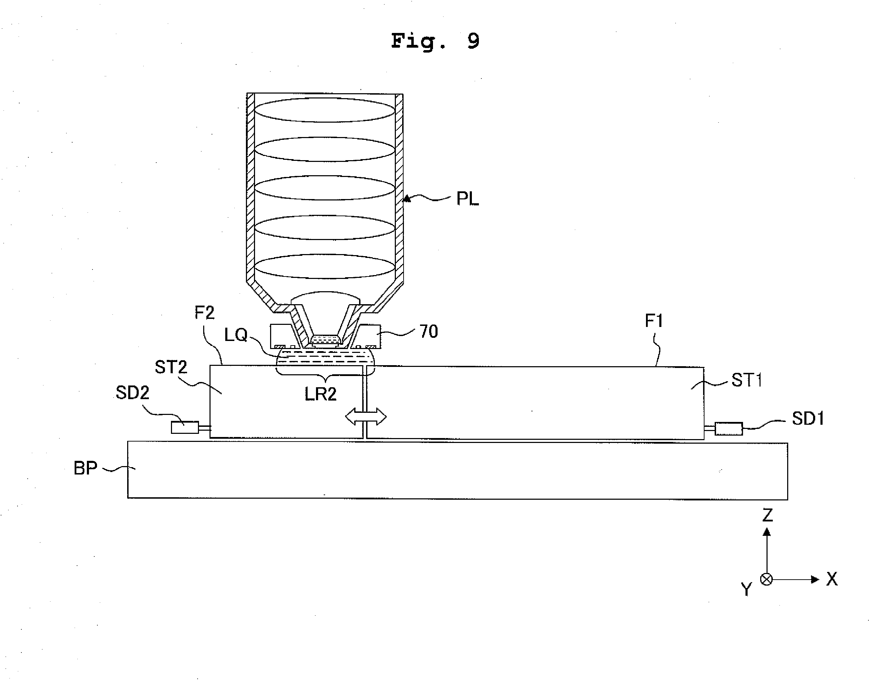

As shown in Fig. 9, the controller CONT is capable of bringing the substrate stage ST1 and the measuring stage ST2 into contact with each other or making the substrate stage ST1 and the measuring stage ST2 approach to each other. The controller CONT is capable of making the adjustment so that the upper surface F1 of the substrate stage ST1 and the upper surface F2 of the measuring stage ST2 have height positions which are approximately same.

As shown in Fig. 9, the image plane-side liquid immersion area LR2, which is formed by the second liquid immersion mechanism 2 on the light-exit side of the first optical element LS1 of the projection optical system PL, is movable between the surface of the substrate stage ST1 and the surface of the measuring stage ST2. When the image plane-side liquid immersion area LR2 is moved, then the controller CONT moves the substrate stage ST1 and the measuring stage ST2 together in the XY directions in a state in which the upper surface F1 of the substrate stage ST1 and the upper surface F2 of the measuring stage ST2 are brought into contact with each other or made to approach to each other by using the stage-driving devices SD1, SD2, and the controller CONT moves the image plane-side liquid immersion area LR2, which is formed by the second liquid immersion mechanism 2, between the upper surface F1 of the substrate stage ST1 and the upper surface F2 of the measuring stage ST2. Accordingly, the image plane-side liquid immersion area LR2 can be moved between the substrate stage ST1 and the measuring stage ST2 in a state in which the image plane-side space K2 of the projection optical system PL is filled with the liquid LQ while suppressing the outflow of the liquid LQ from the interstice (gap) between the substrate stage ST1 and the measuring stage ST2.

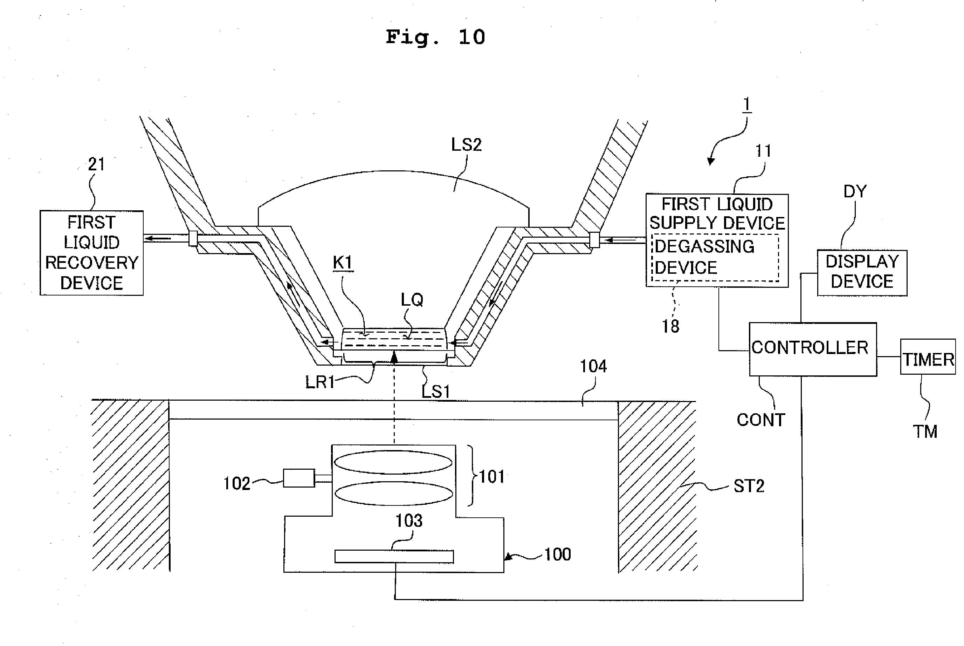

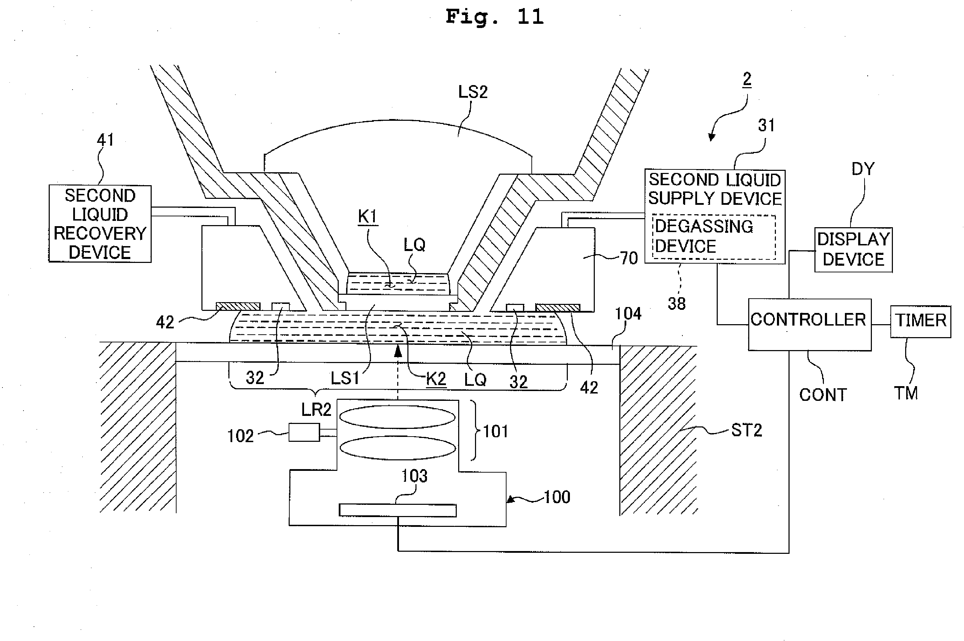

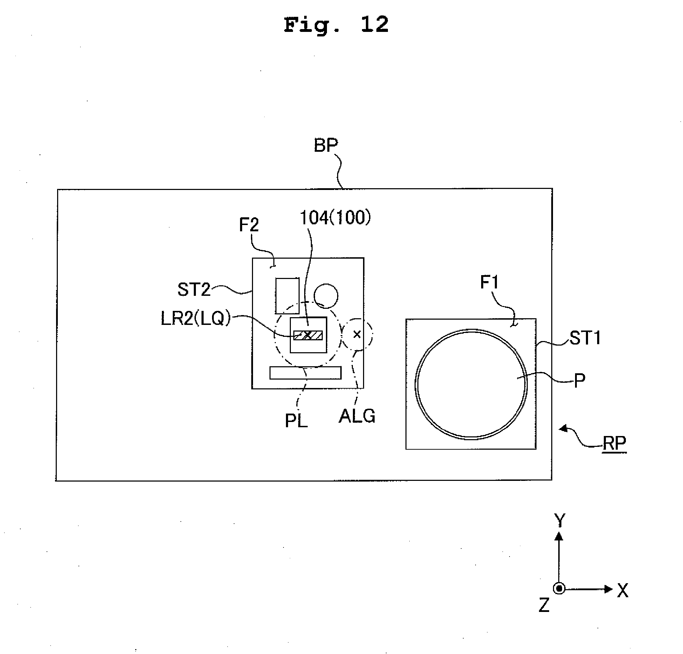

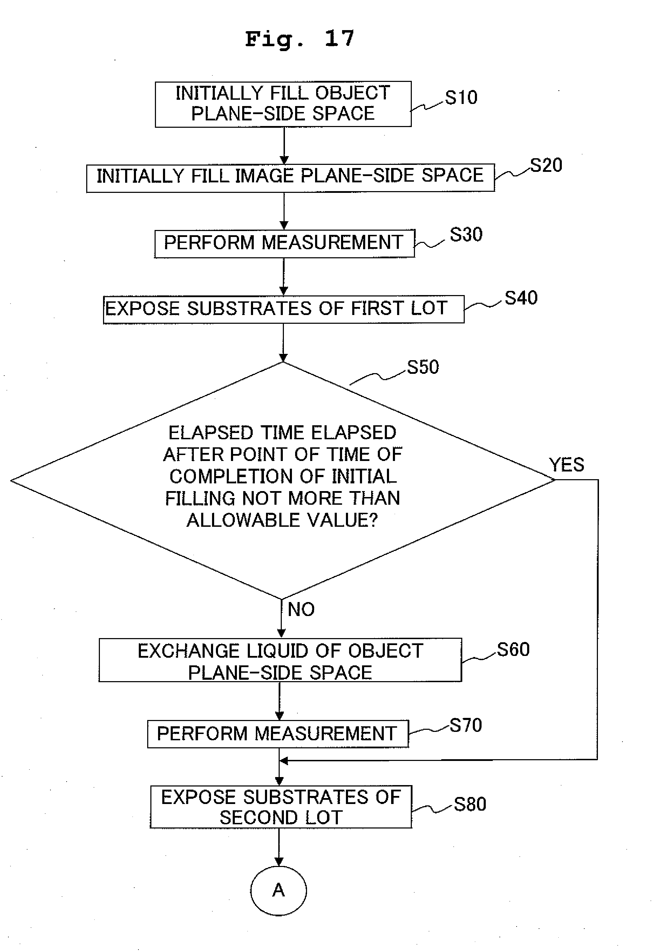

Next, an explanation will be made with reference to Figs. 10 to 22 about the method for exposing the substrate P by using the exposure apparatus EX constructed as described above. Figs. 10 and 11 schematically illustrate states in which the liquid immersion area is observed by using the observing device 100. Figs. 12 to 16 illustrate the substrate stage ST1 and the measuring stage ST2 as viewed from the upper position in order to explain the operations of the substrate stage ST1 and the measuring stage ST2. Figs. 17 to 22 show flow charts illustrating the procedure of the exposure method.

Fig. 17 shows a flow chart illustrating the basic procedure of the exposure apparatus according to this embodiment. At first, the controller CONT fills the object plane-side space K1 with the liquid LQ by supplying the liquid LQ to the object plane-side space K1 by using the first liquid immersion mechanism 1. No liquid LQ is present in the optical path space (K1, K2) in the initial state of the exposure apparatus EX before performing the predetermined operation in relation to the exposure. The controller CONT supplies the liquid LQ to the object plane-side space K1 in which no liquid LQ exists, by using the first liquid immersion mechanism 1.

In the following description, the operation, wherein the liquid LQ is supplied to the optical path space (K1, K2) in order to fill, with the liquid LQ, the optical path space (K1, K2) for the exposure light beam EL in the initial state in which no liquid LQ is present, is appropriately referred to as "initial filling operation". That is, the initial filling operation refers to the operation wherein the optical path space (K1, K2) is filled with the liquid LQ by supplying the liquid LQ to the optical path space (K1, K2) in the state (empty state) in which the liquid LQ is absent.

The controller CONT performs the initial filling operation for the object plane-side space K1 by supplying the liquid LQ to the object plane-side space K1 in which the liquid LQ is absent, by using the first liquid immersion mechanism 1 (Step S10).

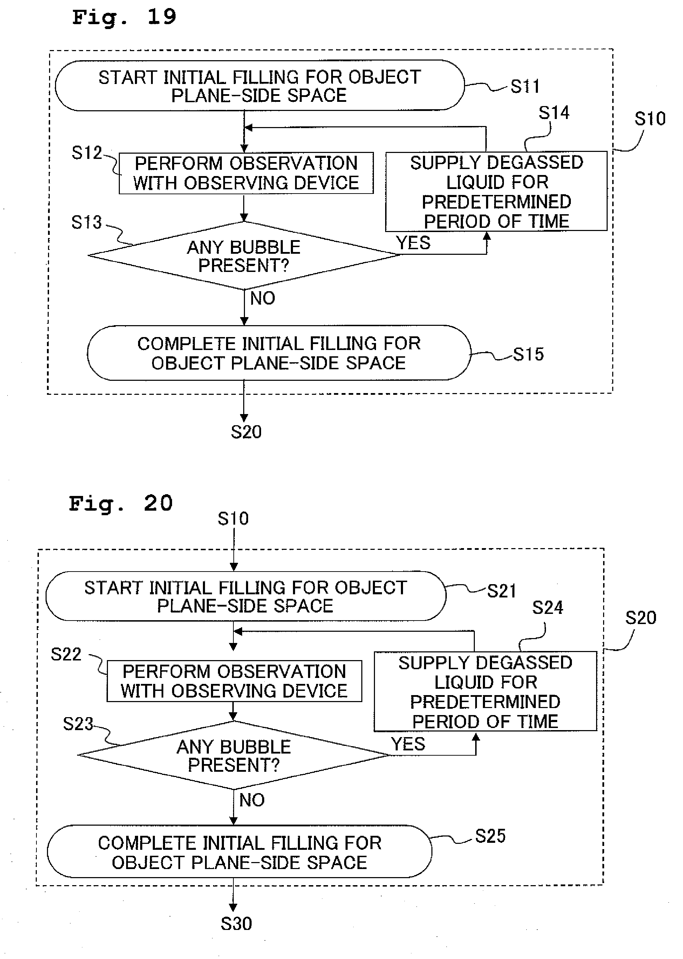

Fig. 19 shows a flow chart illustrating a specific procedure of Step S10. In Step S10 for initially filling the object plane-side space K1, when an instruction to initially fill the object plane-side space K1 is issued (Step S11), as shown in Fig. 10, the controller CONT drives the first liquid immersion mechanism 1 to fill the object plane-side space K1 with the liquid LQ in the state in which the projection optical system PL is opposite to the transparent member 104 disposed on the measuring stage ST2. The controller CONT performs the initial filling operation for the object plane-side space K1 while observing the object plane-side liquid immersion area LR1 formed by the liquid LQ filled in the object plane-side space K1 is filled, by using the observing device 100 (Step S12). When the object plane-side space K1 is subjected to the initial filling, the controller CONT concurrently performs, for a predetermined period of time, the liquid supply operation by the first liquid supply device 11 of the first liquid immersion mechanism 1 and the liquid recovery operation by the first liquid recovery device 21.

The observing device 100 observes the state of the object plane-side liquid immersion area LR1 via the transparent member 104 and the first optical element LS1. When the observing device 100 observes the state of the object plane-side liquid immersion area LR1, the measuring stage ST2 is allowed to substantially stand still. The optical system 101 of the observing device 100 is arranged in the internal space located under or below the transparent member 104. The image pickup element 103 obtains an image of the liquid LQ forming the object plane-side liquid immersion area LR1 via the first optical element LS1, the transparent member 104, and the optical system 101. When the state of the object plane-side liquid immersion area LR1 is observed by using the observing device 100, the controller CONT adjusts the focus position of the optical system 101 to the position of the object plane-side liquid immersion area LR1 in the Z axis direction by using the adjusting mechanism 102. Therefore, the image pickup element 103 can satisfactorily obtain the image of the liquid LQ which forms the object plane-side liquid immersion area LR1. Further, the observing device 100 has the field which is larger than the object plane-side liquid immersion area LR1. Therefore, it is possible to collectively obtain the image of the liquid LQ which forms the object plane-side liquid immersion area LR1.

The image information in relation to the object plane-side liquid immersion area LR1, which is obtained by the image pickup element 103, is outputted to the controller CONT. The controller CONT displays, on the display device DY, the image of the liquid LQ which forms the object plane-side liquid immersion area LR1, based on the signal (image signal) outputted from the image pickup element 103.

The controller CONT performs a calculation process (image processing) for the signal outputted from the image pickup element 103 to judge whether or not the liquid LQ, filled in the object plane-side space K1 is filled, is in the desired state, based on a result of the process. Specifically, the controller CONT judges whether or not any bubble is present in the liquid LQ (Step S13). The judgment is not limited to only the bubble. It is also possible to judge whether or not any gas portion including any gaseous matter or any particle (foreign matter) is present.

For example, in the initial filling operation, any inconvenience may possibly arise, for example, such that the bubble enters into the liquid LQ, and/or a state (liquid-deficient state) occurs in which the object plane-side liquid immersion area LR1 does not sufficiently cover the predetermined area AR1 through which the exposure light beam EL passes. If the exposure process or the measurement process is performed via the object plane-side liquid immersion area LR1 in the state in which the inconvenience arises as described above, it is impossible to obtain any satisfactory exposure accuracy or any satisfactory measurement accuracy. In this embodiment, the state of the object plane-side liquid immersion area LR1 is observed by using the observing device 100. Accordingly, it is possible to grasp whether or not any inconvenience arises in the object plane-side liquid immersion area LR1. The observing device 100 is capable observing (detecting) the bubble having a diameter of, for example, not less than 0.1 mm.

If it is judged in Step S13 that any bubble is absent in the liquid LQ filling the object plane-side space K1 therewith and that the liquid LQ is in the desired state, then the initial filling operation for the object plane-side space K1 is completed (Step S15). That is, the liquid supply operation by the first liquid supply device 11 and the liquid recovery operation by the first liquid recovery device 21 are stopped. In order to stabilize the state (for example, the liquid quality) of the liquid LQ filling the object plane-side space K1 therewith, the liquid supply operation by the first liquid supply device 11 and the liquid recovery operation by the first liquid recovery device 21 may be continued for a predetermined period of time after it is judged that the bubble is absent in the liquid LQ.

On the other hand, if it is judged in Step S13 that the bubble is present in the liquid LQ filling the object plane-side space K1 therewith, the controller CONT supplies a degassed liquid LQ for a predetermined period of time in order to reduce or eliminate the bubble (Step S14). That is, if it is judged that the bubble (gas portion) is present in the liquid LQ for filling the object plane-side space K1 therewith, based on the result of the observation performed by the observing device 100 provided on the measuring stage ST2, then the controller CONT controls the first liquid immersion mechanism 1 so that the degassed liquid LQ is supplied, for a predetermined period of time, to the object plane-side space K1 between the first optical element LS1 and the second optical element LS2, and that a predetermined amount of the liquid LQ is recovered from the object plane-side space K1 based on the supply amount of the degassed liquid LQ. As described above, the first liquid supply device 11 of the first liquid immersion mechanism 1 is provided with the degassing device 18 in order to reduce the gas component in the liquid LQ. Therefore, the controller CONT can control the first liquid immersion mechanism 1 after sufficiently degassing the liquid LQ by using the degassing device 18 provided for the first liquid supply device 11 so that the degassed liquid LQ is supplied to the object plane-side space K1 between the first optical element LS1 and the second optical element LS2. When the sufficiently degassed liquid LQ is supplied to the object plane-side space K1 for a predetermined period of time, then the bubble (gas component), in the liquid LQ forming the object plane-side liquid immersion area LR1, is successfully allowed to flow out, and the bubble (gas portion) can be reduced or eliminated by dissolving the bubble (gas portion) in the liquid LQ.

In this procedure, the liquid supply amount per unit time, which is brought about when the liquid LQ is supplied to the object plane-side space K1 in order to reduce or eliminate the bubble, may be approximately same as the liquid supply amount per unit time which is brought about when the object plane-side space K1 is initially filled. Alternatively, the liquid supply amount per unit time, which is brought about when the liquid LQ is supplied to the object plane-side space K1 in order to reduce or eliminate the bubble, may be larger than the liquid supply amount per unit time which is brought about when the object plane-side space K1 is initially filled.

After supplying the degassed liquid LQ for a predetermined period of time, when it is confirmed that the size or the amount of the bubble contained in the liquid LQ for forming the object plane-side liquid immersion area LR1 is not more than a predetermined level based on the observation result of the observing device 100, then The initial filling for the object plane-side space K1 is completed (Step S15). That is, the liquid supply operation by the first liquid supply device 11 and the liquid recovery operation by the first liquid recovery device 21 are stopped. In order to stabilize the state (for example, the liquid quality) of the liquid LQ filling the object plane-side space K1 therewith, the liquid supply operation by the first liquid supply device 11 and the liquid recovery operation by the first liquid recovery device 21 may be continued for a predetermined period of time after it is judged that the bubble is absent in the liquid LQ.

For example, an operator may judge whether or not the object plane-side liquid immersion area LR1 is in the desired state based on the image of the object plane-side liquid immersion area LR1 displayed on the display device DY. In this case, for example, the operator instructs the next operation to the controller CONT.

If it is judged in Step S13 that the liquid LQ, filled in the object plane-side space K1 is filled, involves any inconvenience, the controller CONT may perform the following operation. That is, the controller CONT stops the supply of the liquid LQ to the object plane-side space K1, and makes all of the liquid LQ to be discharged from the object plane-side space K1; and then the controller CONT returns the routine to Step S11 to execute again the initial filling operation for the object plane-side space K1.

With reference to Fig. 17 again, after the initial filling operation for the object plane-side space K1 is completed, the initial filling operation for the image plane-side space K2 is performed (Step S20). The controller CONT performs the initial filling operation for the image plane-side space K2 by performing the supply operation and the recovery operation for supplying and recovering the liquid LQ with respect to the image plane-side space K2 in which the liquid LQ is absent, by using the second liquid immersion mechanism 2.

Fig. 20 shows a flow chart illustrating a specific procedure of Step S20. In Step S20 for initially filling the image plane-side space K2, when an instruction to initially fill the image plane-side space K2 is issued (Step S21), then as shown in Fig. 11, the controller CONT drives the second liquid immersion mechanism 2 to fill the image plane-side space K2 with the liquid LQ in a state in which the projection optical system PL is opposite to the transparent member 104 disposed on the measuring stage ST2. The controller CONT performs the initial filling for the image plane-side space K2 while observing the image plane-side liquid immersion area LR2 formed by the liquid LQ filled in the image plane-side space K2 is filled, by using the observing device 100 (Step S22).

The controller CONT observes the state of the image plane-side liquid immersion area LR2 formed by the liquid LQ filling the image plane-side space K2 therewith, by using the observing device 100. The observing device 100 observes the state of the image plane-side liquid immersion area LR2 via the transparent member 104. When the observing device 100 observes the state of the image plane-side liquid immersion area LR2, the measuring stage ST2 is allowed to substantially stand still. The image pickup element 103 obtains the image of the liquid LQ forming the image plane-side liquid immersion area LR2 via the transparent member 104 and the optical system 101.

When the state of the image plane-side liquid immersion area LR2 is observed by using the observing device 100, the controller CONT adjusts the focus position of the optical system 101 to the position of the image plane-side liquid immersion area LR2 in the Z axis direction by using the adjusting mechanism 102. Therefore, the image pickup element 103 can satisfactorily obtain the image of the liquid LQ which forms the image plane-side liquid immersion area LR2. Further, the observing device 100 has the field which is larger than the image plane-side liquid immersion area LR2. Therefore, it is possible to collectively obtain the image of the liquid LQ which forms the image plane-side liquid immersion area LR2.

The image information in relation to the image plane-side liquid immersion area LR2, which is obtained by the image pickup element 103, is outputted to the controller CONT. The controller CONT displays, on the display device DY, the image of the liquid LQ which forms the image plane-side liquid immersion area LR2, based on the signal (image signal) outputted from the image pickup element 103.

The controller CONT performs the calculation process (image processing) for the signal outputted from the image pickup element 103 to judge whether or not the liquid LQ, filled in the image plane-side space K2 is filled, is in the desired state, based on a result of the process. Specifically, the controller CONT judges whether or not any bubble is present in the liquid LQ (Step S23). The judgment is not limited to only the bubble. It is also possible to judge whether or not any gas portion including any gaseous matter or any particle (foreign matter) is present.

The state of the image plane-side liquid immersion area LR2 is observed by using the observing device 100, and thus it is possible to grasp whether or not any inconvenience arises in the image plane-side liquid immersion area LR2. The observing device 100 is capable observing (detecting) the bubble having a diameter of, for example, not less than 0.1 mm.

If it is judged in Step S23 that any bubble is absent in the liquid LQ filling the image plane-side space K2 therewith and the liquid LQ is in the desired state, then the initial filling operation for the image plane-side space K2 is completed (Step S25).

On the other hand, if it is judged in Step S23 that the bubble is present in the liquid LQ filling the image plane-side space K2 therewith, the controller CONT supplies the degassed liquid LQ for a predetermined period of time in order to reduce or eliminate the bubble (Step S24). That is, when the controller CONT judges that the bubble (gas portion) is present in the liquid LQ filling the image plane-side space K2 therewith based on the result of the observation performed by the observing device 100 provided on the measuring stage ST2, the controller CONT controls the second liquid immersion mechanism 2 so that the degassed liquid LQ is supplied, for a predetermined period of time, to the image plane-side space K2 between the first optical element LS1 and the transparent member 104, and that a predetermined amount of the liquid LQ is recovered from the image plane-side space K2 based on the supply amount of the degassed liquid LQ. As described above, the second liquid supply device 31 of the second liquid immersion mechanism 2 is provided with the degassing device 38 in order to reduce the gas component in the liquid LQ. Therefore, the controller CONT can control the second liquid immersion mechanism 2 after sufficiently degassing the liquid LQ by using the degassing device 38 provided for the second liquid supply device 31 so that the degassed liquid LQ is supplied to the image plane-side space K2 between the first optical element LS1 and the transparent member 104. When the sufficiently degassed liquid LQ is supplied to the image plane-side space K2 for a predetermined period of time, then the bubble (gas component), in the liquid LQ forming the image plane-side liquid immersion area LR2, is successfully allowed to flow out, and the bubble (gas portion) can be reduced or eliminated. The operation of Step S24 may be executed while moving the measuring stage ST2. For example, the bubble (gas component) in the liquid LQ is successfully allowed to flow out more quickly by allowing the measuring stage ST2 to perform the reciprocating movement in a predetermined direction at a predetermined stroke.

After supplying the degassed liquid LQ for a predetermined period of time, when it is confirmed that the size or the amount of the bubble in the liquid LQ forming the image plane-side liquid immersion area LR2 is not more than a predetermined level based on the observation result of the observing device 100, then the initial filling for the image plane-side space K2 is completed (Step S25). In this embodiment, the liquid supply operation by the second liquid supply device 31 and the liquid recovery operation by the second liquid recovery device 41 are continued even after the completion of the initial filling operation for the liquid LQ filling the image plane-side space K2 therewith, and the liquid LQ filling the image plane-side space K2 therewith is replaced (exchanged).

For example, an operator may judge whether or not the image plane-side liquid immersion area LR2 is in the desired state based on the image of the image plane-side liquid immersion area LR2 displayed on the display device DY. In this case, for example, the operator instructs the next operation to the controller CONT.

If it is judged in Step S23 that the liquid LQ, filled in the image plane-side space K2, involves any inconvenience, the controller CONT may perform the following operation. That is, the controller CONT stops the supply of the liquid LQ to the image plane-side space K2, and makes all of the liquid LQ to be discharged from the image plane-side space K2; and then the controller CONT returns the routine to Step S21 to execute again the initial filling operation for the image plane-side space K2.

Fig. 12 shows a state in which the initial filling operation is performed for the object plane-side space K1 or the image plane-side space K2 while observing the object plane-side liquid immersion area LR1 or the image plane-side liquid immersion area LR2 by using the observing device 100. In this situation, as shown in Fig. 12, the substrate stage ST1 waits at a substrate exchange position RP.

In this embodiment, although the object plane-side space K1, which is between the first optical element LS1 and the second optical element LS2, is filled with the liquid LQ during the exposure for one lot constituted of a predetermined number of the substrates P after the completion of the initial filling for the object plane-side space K1, the first liquid immersion mechanism 1 does not perform the supply operation and the recovery operation for supplying and recovering the liquid LQ. Accordingly, it is possible to avoid the generation of vibration caused by the liquid supply operation and the recovery operation performed by the first liquid immersion mechanism 1 during the exposure for the substrate P. It is assumed that the first liquid immersion mechanism 1 fills the object plane-side space K1 with the liquid LQ, and the first liquid immersion mechanism 1 exchanges, at a predetermined timing, the liquid LQ filled in the object plane-side space K1. On the other hand, the second liquid immersion mechanism 2 concurrently continues the supply operation for supplying the liquid LQ to the image plane-side space K2 and the recovery operation for recovering the liquid LQ from the image plane-side space K2 after the completion of the initial filling for the image plane-side space K2 to always fill the image plane-side space K2 with the liquid LQ.

In this procedure, in the exchange operation for exchanging the liquid LQ of the object plane-side space K1, the supply operation for supplying the liquid LQ to the object plane-side space K1 and the recovery operation for recovering the liquid LQ from the object plane-side space K1, which are performed by the first liquid immersion mechanism 1, are concurrently started in a state in which the object plane-side space K1 is filled with the liquid LQ. The liquid LQ, formerly filled in the object plane-side space K1, is recovered from the object plane-side space K1, and the new liquid LQ, which is clean and which is adjusted to have a predetermined temperature, is supplied to the object plane-side space K1.

That is, when the liquid LQ of the object plane-side liquid immersion area LR1 is exchanged, the liquid LQ, formerly filled in the object plane-side space K1, is gradually replaced with the new liquid LQ so that the object plane-side space K1 is always filled with the liquid LQ, without completely removing the liquid LQ from the object plane-side space K1. Accordingly, it is possible to suppress the formation of the bubble (gas portion) in the liquid LQ of the object plane-side liquid immersion area LR1, which would be otherwise caused by the exchange of the liquid LQ of the object plane-side liquid immersion area LR1.

Of course, it is also allowable to adopt the following procedure. That is, the liquid LQ of the object plane-side space K1 is completely recovered (discharged) so that the object plane-side space K1 becomes a space which is filled with the gas. After that, the new liquid LQ, which is clean and which is adjusted to have the predetermined temperature, is supplied to the object plane-side space K1 in the same manner as in the initial filling operation to form the object plane-side liquid immersion area LR1.

The liquid LQ, filled in the object plane-side space K1, is irradiated with the exposure light beam EL. Therefore, there is such a possibility that the liquid LQ, filled in the object plane-side space K1, may undergo the increase in the temperature due to the radiation heat of the exposure light beam EL. Further, the following possibility may arise. That is, the liquid LQ may be polluted by the liquid LQ remaining for a long period of time in the object plane-side space K1, and any influence may be exerted, for example, on a member which makes contact with the liquid LQ, including, for example, the first optical element LS1 and the second optical element LS2. Therefore, as in this embodiment, when the liquid LQ of the object plane-side space K1 is not always replaced, the liquid LQ of the object plane-side space K1 is exchanged at a predetermined timing. Accordingly, it is possible to suppress the inconvenience including, for example, the pollution and the temperature increase of the liquid LQ filled in the object plane-side space K1. The object plane-side space K1 can be filled with the liquid LQ in the desired state (desired temperature and desired cleanness) .

With reference to Fig. 17 again, after the initial filling operation is completed, the controller CONT executes the predetermined measurement process using the measuring device (measuring member) on the measuring stage ST2 (Step S30).

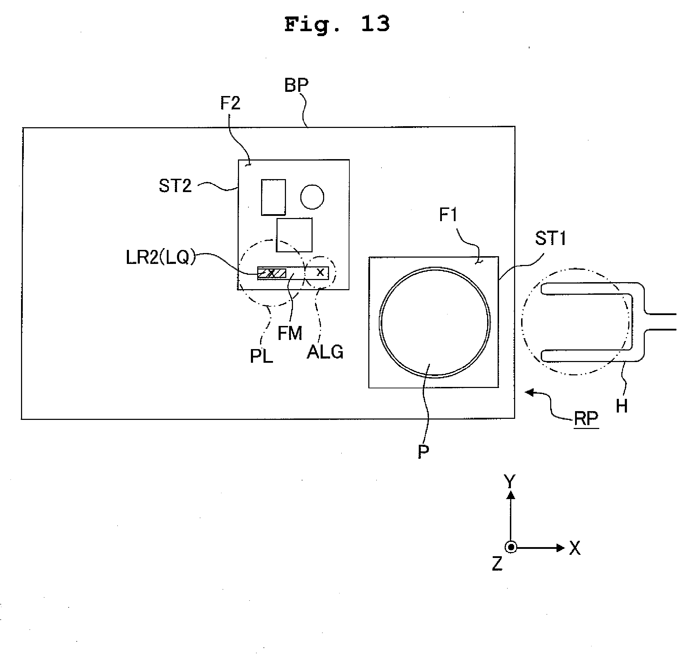

The measurement can be exemplified by the base line measurement of the alignment system ALG. Specifically, as shown in Fig. 13, the controller CONT makes the first optical element LS1 of the projection optical system PL to be opposite to the measuring stage ST2, and detects the first reference mark on the reference mark plate FM provided on the measuring stage ST2 and the mask alignment mark on the mask M corresponding thereto by using the mask alignment system RA described above to detect the positional relationship between the first reference mark and the mask alignment mark corresponding thereto. Simultaneously therewith, the controller CONT detects the second reference mark on the reference mark plate FM by the alignment system ALG to thereby detect the positional relationship between the detection reference position of the alignment system ALG and the second reference mark. As described above, in this embodiment, the controller CONT performs the measurement using the mask alignment system RA in the state in which the space between the projection optical system PL and the reference mark plate FM (first reference mark) is filled with the liquid LQ by using the second liquid immersion mechanism 2. In this way, the mask alignment system RA performs the measurement via the projection optical system PL and the liquid LQ. The controller CONT determines the distance (positional relationship) between the projection center of the mask pattern brought about by the projection optical system PL and the detection reference position of the alignment system ALG, i.e., the base line information of the alignment system ALG based on the positional relationship between the first reference mark and the mask alignment mark corresponding thereto, the positional relationship between the detection reference position of the alignment system ALG and the second reference mark, and the known positional relationship between the first reference mark and the second reference mark. Fig. 13 shows the state brought about in this situation.

In the base line measurement, it is also allowable that the detection of the first reference mark by the mask alignment system RA and the detection of the second reference mark by the alignment system ALG are not performed simultaneously; and one of the detection of the first reference mark by the mask alignment system RA and the detection of the second reference mark by the alignment system ALG may be performed, and then the other of the detections may be executed after moving the measuring stage ST2 while performing the monitoring with the laser interferometer 56.

The controller CONT loads the substrate P, to be subjected to the exposure process, on the substrate stage ST1 by using a transport device H at the substrate exchange position RP of the substrate stage ST1 during the period in which the measuring operation is performed by using the measuring device (measuring member) provided on the measuring stage ST2. The substrate P, which is disposed at the head of the first lot, is loaded on the substrate stage ST1. In this procedure, when the substrate P, for which the exposure is completed, is held on the substrate stage ST1, the substrate P, for which the exposure is completed, is unloaded from the substrate stage ST by the controller CONT by using the transport device H.

The measuring operation which uses the measuring stage ST2 is not limited to the base line measurement, and also includes the measuring operation which uses the spatial image-measuring sensor 160. When the measuring operation using the spatial image-measuring sensor 160 is performed, the controller CONT forms, on the upper plate 165 of the measuring stage ST2, the image plane-side liquid immersion area LR2 formed by the second liquid immersion mechanism 2. The exposure light beam EL is received via the liquid LQ between the projection optical system PL and the upper plate 165 and the slit 161 formed for the upper plate 165 to measure the imaging characteristic of the projection optical system PL. Similarly, if necessary, the measurement process is performed by using, for example, the unevenness sensor, the radiation amount sensor, and the wavefront aberration-measuring device. The unevenness sensor, the radiation amount sensor, the wavefront aberration-measuring device and the like also perform the measurement via the projection optical system PL and the liquid LQ. The controller CONT reflects the measurement result on the exposure for the substrate P to be performed thereafter, for example, performing the calibration process for the projection optical system PL based on the measurement result. Specifically, the controller CONT can adjust the imaging characteristic via the projection optical system PL and the liquid LQ by using the imaging characteristic-adjusting device LC described above, based on the measurement result obtained by the measuring device provided on the measuring stage ST2.

The imaging characteristic-adjusting device LC is not limited to only to a device performing the adjustment of the projection optical system PL. The imaging characteristic-adjusting device LC may be a device which moves the mask M, or which adjusts the wavelength of the exposure light beam EL. The positional relationship between the projection optical system PL and the surface of the substrate P as the exposure objective may be also adjusted based on the measurement result obtained by the measuring device provided on the measuring stage ST2.

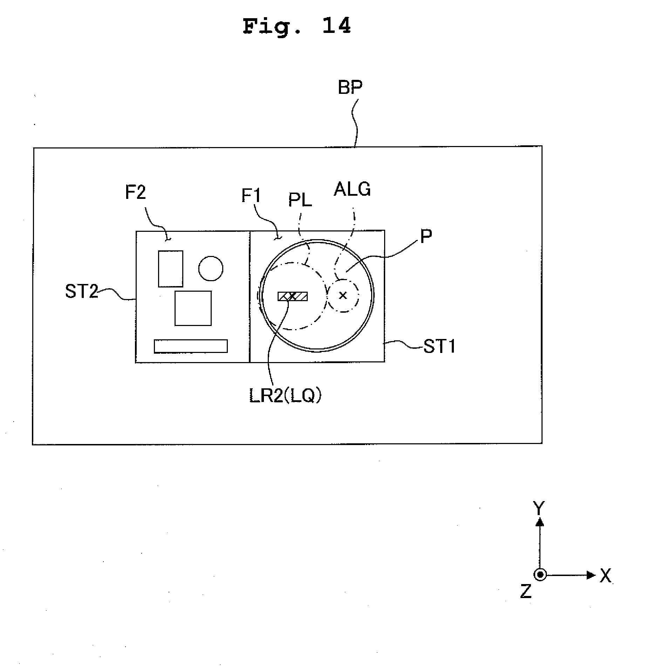

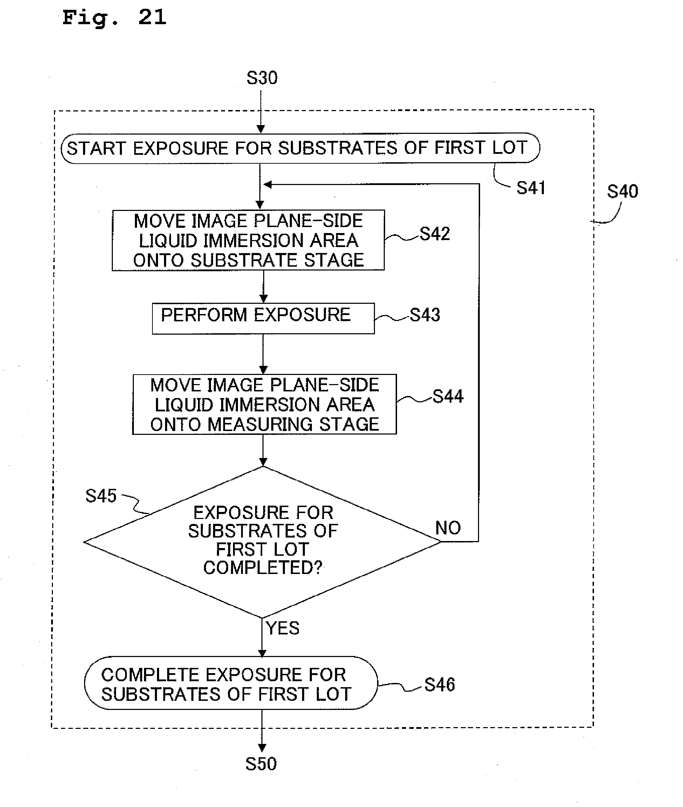

The exposure process is started for a predetermined number of the substrates of the first lot after the loading of the substrate P on the substrate stage ST1 is completed and the measurement is completed by using the measuring device (measuring member) on the measuring stage ST2 (Step S40). Fig. 21 shows a flow chart illustrating a specific procedure of Step S40. When the exposure process is started for the substrate of the first lot (Step S41), the controller CONT moves at least one of the substrate stage ST1 and the measuring stage ST2 by using the stage-driving devices SD1, SD2; the controller CONT moves, as shown in Fig. 14, the substrate stage ST1 and the measuring stage ST2 to bring the substrate stage ST1 and the measuring stage ST2 into contact with each other (or makes the substrate stage ST1 and the measuring stage ST2 approach to each other); and the controller CONT maintains the relative positional relationship to move the substrate stage ST1 and the measuring stage ST2 in the XY plane, so as to perform the alignment process for the substrate P after being loaded on the substrate stage ST1. In this procedure, the substrate stage ST1 and the measuring stage ST2 are moved to thereby move, to the upper surface F1 of the substrate stage ST1 as shown in Fig. 14, the image plane-side liquid immersion area LR2 which has been formed between the first optical element LS1 of the projection optical system PL and the upper surface F2 of the measuring stage ST2. Specifically, in the alignment process, the controller CONT detects the alignment mark on the substrate P, after the exchange by the alignment system ALG, to determine a position coordinate (arrangement coordinate) of each of a plurality of shot areas provided on the substrate P. When the alignment process is performed in the state in which the substrate stage ST1 and the measuring stage ST2 are brought into contact with each other (or made to approach to each other), for example, even if a situation arises such that a part of the image plane-side liquid immersion area LR2 is deviated from the upper surface F1 of the substrate stage ST1 during the alignment process, then the liquid LQ can be retained between the projection optical system PL and at least a part of the upper surface F1 of the substrate stage ST1 and the upper surface F2 of the measuring stage ST2.

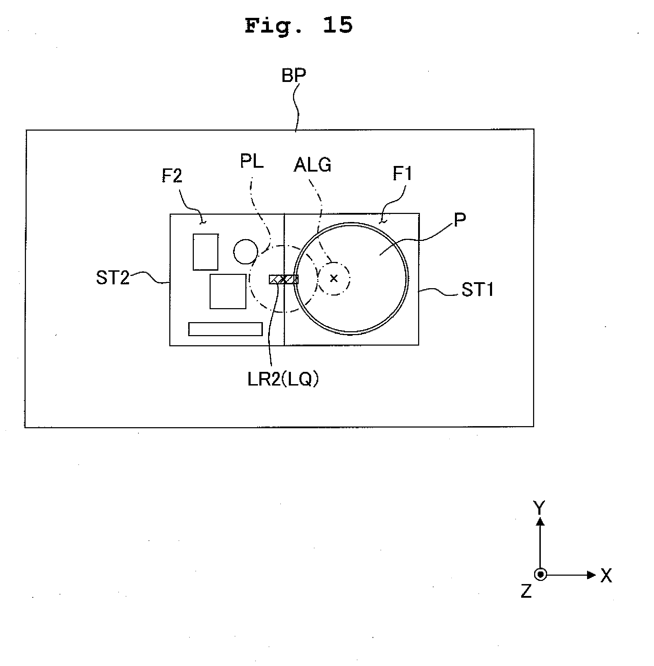

In this embodiment, a position (shot area) on the substrate, at which the alignment mark is detected lastly in the substrate, is the position closer the measuring stage ST2. Therefore, the image plane-side liquid immersion area LR2 is formed on the measuring stage ST2 at the completion of the alignment process. When the alignment process is completed, the controller CONT moves the substrate stage ST1 and the measuring stage ST2 together in the -X direction by using the stage-driving devices SD1, SD2, while maintaining the relative positional relationship in the X axis direction between the substrate stage ST1 and the measuring stage ST2. The controller CONT moves the image plane-side liquid immersion area LR2, which is formed between the first optical element LS1 of the projection optical system PL and the upper surface F2 of the measuring stage ST2, from the upper surface F2 of the measuring stage ST2 to the upper surface F1 of the substrate stage ST1 by moving the substrate stage ST1 and the measuring stage ST2 together (Step S42). The image plane-side liquid immersion area LR2 of the liquid LQ, which is formed by the second liquid immersion mechanism 2, is formed to range over the upper surface F2 of the measuring stage ST2 and the upper surface F1 of the substrate stage ST1 as shown in Fig. 15 during the process in which the image plane-side liquid immersion area LR2 of the liquid LQ is moved from the upper surface F2 of the measuring stage ST2 to the upper surface F1 of the substrate stage ST1. However, the both stages are brought into contact with each other or made to approach to each other. Therefore, it is possible to avoid the leakage of the liquid LQ from any space between the both stages. Then, when the substrate stage ST1 and the measuring stage ST2 are further moved together from the state shown in Fig. 15 in the -X direction by a predetermined distance, a state is given, in which the liquid LQ is retained between the first optical element LS1 of the projection optical system PL and the substrate stage ST1 (substrate P). The image plane-side liquid immersion area LR2 of the liquid LQ, which is formed by the second liquid immersion mechanism 2, is arranged on the upper surface F1 of the substrate stage ST1 including the surface of the substrate P.

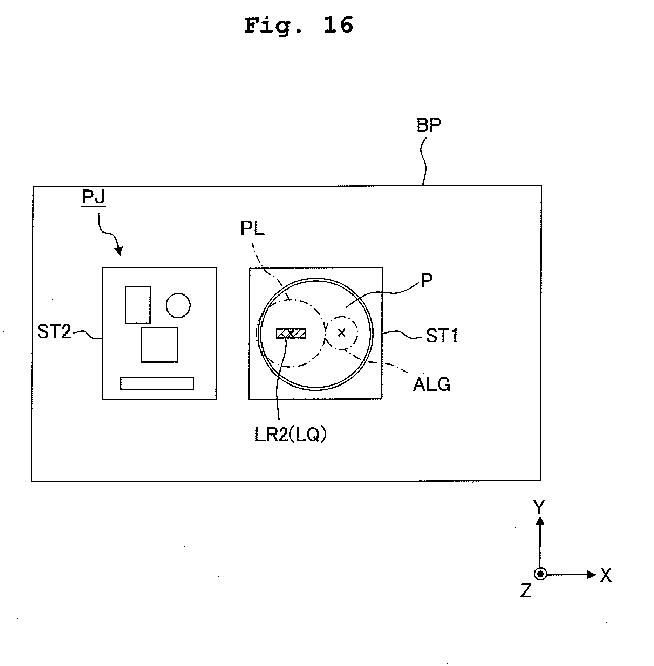

When the movement of the image plane-side liquid immersion area LR2 onto the substrate stage ST1 is completed, the controller CONT separates the measuring stage ST2 from the substrate stage ST1 as shown in Fig. 16, and moves the measuring stage ST2 to a predetermined retraction position PJ to expose the substrate P (Step S43) .

In Step S43, the controller CONT successively transfers the pattern of the mask M onto the plurality of shot areas on the substrate P respectively. The positional adjustment is performed for the respective shot areas on the substrate P with respect to the mask M based on the position coordinates of the plurality of shot areas on the substrate P obtained as the result of the detection of the alignment mark on the substrate P as described above and the base line information measured immediately therebefore.

After completing the liquid immersion exposure for the substrate P on the substrate stage ST1, the controller CONT moves at least one of the substrate stage ST1 and the measuring stage ST2 by using the stage-driving devices SD1, SD2 so that the upper surface F1 of the substrate stage ST1 and the upper surface F2 of the measuring stage ST2 are brought into contact with each other (or made to approach to each other). Reversely to the above, the controller CONT moves the both stages ST1, ST2 together in the +X direction while maintaining the relative positional relationship in the X axis direction between the substrate stage ST1 and the measuring stage ST2; and the controller CONT moves the measuring stage ST2 to a position under or below the projection optical system PL, and then the controller CONT retracts or moves the substrate stage ST1 to a predetermined position such as the substrate exchange position RP (see Fig. 13). Accordingly, the image plane-side liquid immersion area LR2, which is formed by the second liquid immersion mechanism 2, is moved to the upper surface F2 of the measuring stage ST2 (Step 44). The controller CONT performs the substrate exchange operation by using the transport device H such that the exposed substrate P is unloaded from the substrate stage ST1 moved to the substrate exchange position RP, and a substrate P, which is to be subjected to the exposure process next, is loaded on the substrate stage ST1.

As described above, the controller CONT arranges the measuring stage ST2 at the position at which the measuring stage ST2 is opposite to the first optical element LS1 in order to continuously fill, with the liquid LQ, the image plane-side space K2 on the light-exit side of the first optical element LS1 when the substrate stage ST1 is separated from the projection optical system PL, for example, for the purpose of the exchange of the substrate P. The controller CONT performs the measurement by using the respective measuring devices arranged for the measuring stage ST2, if necessary, in the state in which the space between the first optical element LS1 and the measuring stage ST2 is filled with the liquid LQ by using the second liquid immersion mechanism 2 when the measuring stage ST2 is opposite to the first optical element LS1. The result of the measurement is reflected on the exposure for the substrate to be performed thereafter. In this procedure, at least one measuring device disposed on the measuring stage ST2 is selected as necessary every time when the substrate is exchanged, and the measurement result, which is obtained by using the at least one selected measuring device, is reflected on the exposure to be performed thereafter. Therefore, the exposure can be executed highly accurately for each of the substrates P.

During the substrate exchange operation , at least one of the object plane-side liquid immersion area LR1 and the image plane-side liquid immersion area LR2 may be observed by using the observing device 100 provided on the measuring stage ST2. In this case, for example, when any gas portion is found in the liquid LQ by the observing device 100, the exposure for the next substrate P may be started after reducing or eliminating the bubble in the liquid LQ by, for example, continuously flowing the degassed liquid LQ or by replacing (exchanging) the liquid LQ.

In the same manner as described above, the alignment process is performed for the substrate P after being loaded on the substrate stage ST1, and then the exposure process is performed for the substrate P. The controller CONT successively exposes the predetermined number of the substrates P which constitute the first lot by repeating the operation in which the substrate P on the substrate stage ST1 is exposed, the operation in which the image plane-side liquid immersion area LR2 is moved onto the measuring stage ST2, the operation in which the substrate P is exchanged, the operation in which the image plane-side liquid immersion area LR2 is moved onto the substrate stage ST1 loaded with the substrate P, and the like, as described above.

Then, it is judged whether or not the exposure is completed for the substrates P of the first lot constituted of the predetermined number of the substrates P (Step S45). If the exposure is not completed, the operations as described above are repeated. Accordingly, the exposure is completed for the predetermined number of the substrates P which constitute the first lot (Step S46).

In the embodiment described above, the state, in which the substrate stage ST1 and the measuring stage ST2 are brought into contact with each other or made to approach to each other, is maintained from the start to the end of the alignment process. However, it is also allowable that the substrate stage ST1 and the measuring stage ST2 are brought into contact with each other or made to approach to each other in only a part of the period during the alignment process. In this case, during the alignment process, the measuring stage ST2 may be separated from the substrate stage ST1 at the point of time at which the movement of the image plane-side liquid immersion area LR2 from the measuring stage ST2 to the substrate stage ST1 is completed. Alternatively, the image plane-side liquid immersion area LR2 may be moved from the measuring stage ST2 to the substrate stage ST1 while bringing the substrate stage ST1 and the measuring stage ST2 into contact with each other or making the substrate stage ST1 and the measuring stage ST2 to approach to each other, and then the alignment process may be started after separating the measuring stage ST2 from the substrate stage ST1. Further alternatively, the alignment process may be executed without bringing the substrate stage ST1 and the measuring stage ST2 into contact with each other or making the substrate stage ST1 and the measuring stage ST2 approach to each other while forming the image plane-side liquid immersion area LR2 on the measuring stage ST2, then the substrate stage ST1 and the measuring stage ST2 may be brought into contact with each other or made to approach to each other after the completion of the alignment process; and then the image plane-side liquid immersion area LR2 may be moved from the measuring stage ST2 to the substrate stage ST1.

If it is feared that the image plane-side liquid immersion area LR2 protrudes from the substrate stage ST1 during the exposure for the substrate P held by the substrate stage ST1, it is also allowable to adopt the following procedure. That is, the substrate stage ST1 and the measuring stage ST2 are brought into contact with each other or made to approach to each other in at least a part of the period during the exposure for the substrate P.

With reference to Fig. 17 again, after the completion of the exposure for the substrates P of the first lot, the controller CONT exchanges the mask M on the mask stage MST with another mask M. Further, the controller CONT judges whether or not the liquid LQ, filled in the object plane-side space K1, is to be exchanged, based on the elapsed time elapsed after the point of time (i.e., Step S10) at which the initial filling is completed for the object plane-side space K1. Specifically, the controller CONT starts the time measurement by using the timer TM at the point of time at which the initial filling is completed for the object plane-side space K1; and the controller CONT judges whether or not the elapsed time, elapsed after the point of time (i.e., Step S10) of the completion of the initial filling for the object plane-side space K1, exceeds a preset allowable value (Step S50).

The allowable value herein refers to an allowable value of time capable of maintaining, in the desired state, the liquid LQ filled in the object plane-side space K1. If the elapsed time is not more than the allowable value, the state, which includes the temperature and the cleanness of the liquid LQ filling the object plane-side space K1 therewith, is maintained to be the desired state. Therefore, if the elapsed time is not more than the allowable value, even when the liquid LQ is not exchanged, then the object plane-side space K1 is filled with the clean liquid LQ in the desired state having the desired temperature. On the other hand, if the elapsed time is not less than the allowable value, the temperature and the cleanness of the liquid LQ filling the object plane-side space K1 therewith are not in the desired state, and it is necessary to exchange the liquid LQ. The allowable value can be previously determined by an experiment or simulation, and is stored in the controller CONT.

If it is judged in Step S50 that the elapsed time elapsed after the point of time of the completion of the initial filling for the object plane-side space K1 is not less than the allowable value, the controller CONT exchanges the liquid LQ of the object plane-side space K1 (Step S60).

The controller CONT concurrently performs, for a predetermined period of time, the supply operation for supplying the liquid LQ to the object plane-side space K1 and the recovery operation for recovering the liquid LQ from the object plane-side space K1 by the first liquid immersion mechanism 1 in order to exchange the liquid LQ of the object plane-side space K1. When the liquid LQ of the object plane-side space K1 is exchanged, the controller CONT moves the measuring stage ST2 to the position at which the transparent member 104 is opposite to the projection optical system PL, and the controller CONT exchanges the liquid LQ while observing the liquid LQ of the object plane-side space K1 with the observing device 100 provided on the measuring stage ST2.

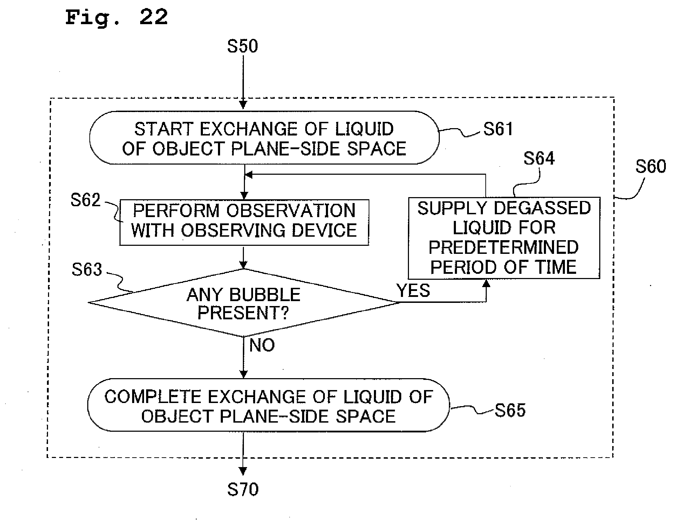

Fig. 22 shows a flow chart illustrating a specific procedure of Step S60. When the instruction to exchange the liquid LQ of the object plane-side space K1 is issued (Step S61) in Step S60 for exchanging the liquid LQ of the object plane-side space K1, the controller CONT performs the operation for exchanging the liquid LQ of the object plane-side space K1 by using the first liquid immersion mechanism 1 in a state in which the projection optical system PL is opposite to the transparent member 104 disposed on the measuring stage ST2. The controller CONT exchanges the liquid LQ of the object plane-side space K1 (Step S62) while observing the object plane-side liquid immersion area LR1 formed by the liquid LQ filled in the object plane-side space K1, by using the observing device 100. In this embodiment, it is judged that the exchange of the liquid LQ of the object plane-side space K1 is completed by executing, for the predetermined period of time, the supply operation and the recovery operation for supplying and recovering the liquid LQ with respect to the object plane-side space K1. However, it is also allowable that the state (for example, the temperature and the liquid quality) of the liquid LQ recovered from the object plane-side space K1 is checked to judge whether or not the exchange of the liquid LQ of the object plane-side space K1 is completed, based on an obtained result.

The controller CONT observes the state of the object plane-side liquid immersion area LR1 by using the observing device 100. In this situation, the supply operation and the recovery operation for supplying and recovering the liquid LQ with respect to the image plane-side space K2 are continuously executed by the second liquid immersion mechanism 2. Therefore, the image plane-side space K2 is always filled with the liquid LQ, and the observing device 100 observes the state of the object plane-side liquid immersion area LR1 via the transparent member 104, the image plane-side liquid immersion area LR2, and the first optical element LS1. When the observing device 100 observes the state of the object plane-side liquid immersion area LR1, the measuring stage ST2 is allowed to substantially stand still. When the state of the object plane-side liquid immersion area LR1 is observed by using the observing device 100, the controller CONT adjusts the focus position of the optical system 101 to the position of the object plane-side liquid immersion area LR1 in the Z axis direction by using the adjusting mechanism 102. Therefore, the image pickup element 103 is capable of satisfactorily obtaining the image of the liquid LQ which forms the object plane-side liquid immersion area LR1. When the state of the object plane-side liquid immersion area LR1 is observed by using the observing device 100, the supply operation and the recovery operation for supplying and recovering the liquid LQ, which are to be performed by the second liquid immersion mechanism 2, may be stopped.

The image information in relation to the object plane-side liquid immersion area LR1, which is obtained by the image pickup element 103, is outputted to the controller CONT. The controller CONT displays, on the display device DY, the image of the liquid LQ which forms the object plane-side liquid immersion area LR1, based on the signal (image information) outputted from the image pickup element 103.

The controller CONT performs the calculation process (image processing) for the signal outputted from the image pickup element 103 to judge whether or not the liquid LQ, filled in the object plane-side space K1, is in the desired state, based on the result of the process. Specifically, the controller CONT judges whether or not any bubble is present in the liquid LQ (Step S63). The judgment is not limited to only the bubble. It is also possible to judge whether or not any gas portion including any gaseous matter or any particle is present.

If it is judged in Step S63 that any bubble is absent in the liquid LQ filling the object plane-side space K1 therewith and that the liquid LQ is in the desired state, the exchange operation for exchanging the liquid LQ of the object plane-side space K1 is completed (Step S65). That is, the supply operation and the recovery operation of the first liquid immersion mechanism 1 for supplying and recovering the liquid LQ with respect to the object plane-side space K1 are stopped.

On the other hand, if it is judged in Step S63 that the bubble is present, for example, in the liquid LQ filling the object plane-side space K1 therewith, the controller CONT supplies the degassed liquid LQ for a predetermined period of time in order to reduce or eliminate the bubble (Step S64). That is, when it is judged that the bubble (gas portion) is present in the liquid LQ filling the object plane-side space K1 therewith, based on the observation result of the observing device 100 provided on the measuring stage ST2, the controller CONT controls the first liquid immersion mechanism 1 so that the degassed liquid LQ is supplied, for a predetermined period of time, to the object plane-side space K1 between the first optical element LS1 and the second optical element LS2, and that a predetermined amount of the liquid LQ is recovered from the object plane-side space K1 based on the supply amount of the degassed liquid LQ. As described above, the first liquid supply device 11 of the first liquid immersion mechanism 1 is provided with the degassing device 18 to reduce the gas component in the liquid LQ. Therefore, after the controller CONT sufficiently degasses the liquid LQ by using the degassing device 18 provided for the first liquid supply device 11, the controller CONT can control the first liquid immersion mechanism 1 to supply the degassed liquid LQ to the object plane-side space K1 between the first optical element LS1 and the second optical element LS2. The bubble (gas portion), in the liquid LQ forming the object plane-side liquid immersion area LR1, is successfully allowed to flow out, and/or the bubble (gas component) can be reduced or eliminated by dissolving the bubble (gas component) in the liquid LQ by supplying, for the predetermined period of time, the sufficiently degassed liquid LQ to the object plane-side space K1.

After supplying the degassed liquid LQ for a predetermined period of time, it is confirmed that the size or the amount of the bubble in the liquid LQ forming the object plane-side liquid immersion area LR1 is not more than a predetermined level, based on the observation result of the observing device 100; and then the exchange of the liquid LQ of the object plane-side space K1 is completed (Step S65). That is, the supply operation and the recovery operation performed by the first liquid immersion mechanism 1 for supplying and recovering the liquid LQ with respect to the object plane-side space K1 are stopped.

For example, an operator may judge whether or not the object plane-side liquid immersion area LR1 is in the desired state based on the image of the object plane-side liquid immersion area LR1 displayed on the display device DY. In this case, the operator or the like instructs the next operation to the controller CONT.

After the completion of the exchange of the liquid LQ of the object plane-side space K1, the controller CONT executes the measurement process via the liquid LQ by using the various measuring devices provided on the measuring stage ST2 in the same manner as in above-described Step S30 in the state in which the projection optical system PL and the measuring stage ST2 are opposite to each other, before exposing a predetermined number of the substrates P of the second lot (Step S70). After performing the measurement process in relation to the exposure process through the liquid LQ, the image plane-side liquid immersion area LR2 is moved onto the substrate stage ST1 in the same manner as described above. In this situation, the substrate P, which is disposed at the head of the second lot, has been already loaded on the substrate stage ST1. The controller CONT performs the alignment process for the substrate P at the head of the second lot, and then the controller CONT performs the liquid immersion exposure for the substrate P through the liquid LQ filling object plane-side space K1 therewith and the liquid LQ filling the image plane-side space K2 therewith in accordance with the same procedure as the procedure explained with reference to, for example, Fig. 21. The controller CONT successively exposes the predetermined number of the substrates P constituting the second lot by repeating the same operations as those adopted when the substrates P of the first lot are exposed (Step S80).

On the other hand, if it is judged in Step S50 that the elapsed time elapsed after the point of time of the completion of the initial filling for the object plane-side space K1 is not more than the allowable value, the controller CONT starts the exposure process for the substrates P of the second lot through the liquid LQ filled in the object plane-side space K1, without exchanging the liquid LQ of the object plane-side space K1.

As described above, it is judged whether or not the liquid LQ, filled in the object plane-side space K1, is to be exchanged, based on the elapsed time elapsed after the point of time of the completion of the initial filling to expose the substrate P through the liquid LQ in the desired state. Accordingly, when the elapsed time is not less than the allowable value, then the liquid LQ is exchanged, and thus the object plane-side space K1 is filled with the liquid LQ having the desired temperature and cleanness. On the other hand, when the elapsed time is not more than the allowable value, it is possible to omit the operation which would be otherwise performed such that the liquid LQ is exchanged although the liquid LQ, filled in the object plane-side space K1, is in the desired state. Therefore, it is possible to improve the throughput and the rate of operation of the exposure apparatus EX.

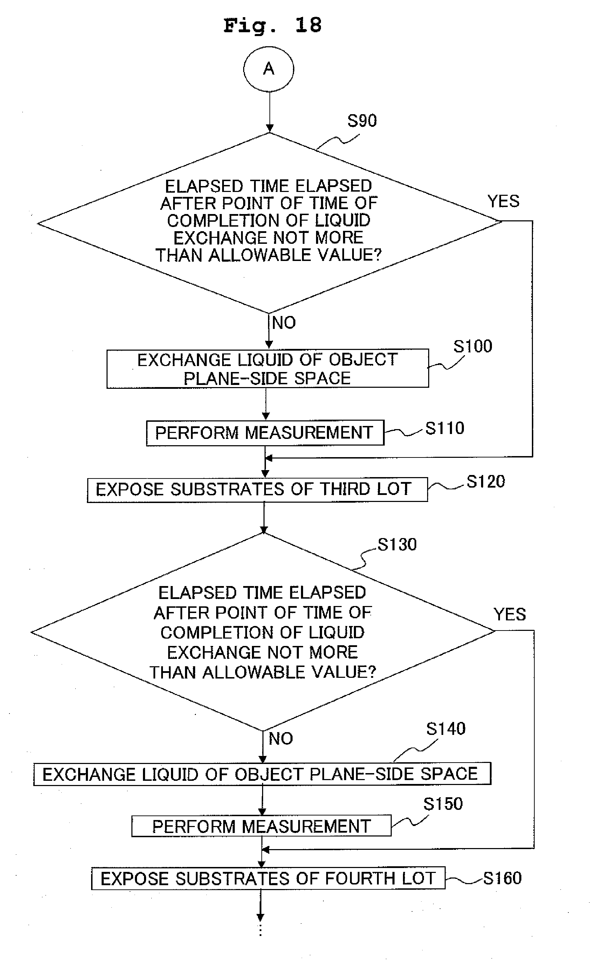

As shown in Fig. 18, after the exposure for the substrate P of the second lot is completed, the controller CONT exchanges the mask M on the mask stage MST with another mask M, and the controller CONT judges whether or not the liquid LQ, filled in the object plane-side space K1, is to be exchanged, based on the elapsed time elapsed after the point of time (i.e., Step S60) at which the liquid LQ filling the object plane-side space K1 therewith was exchanged. Specifically, the controller CONT starts the time measurement by using the timer TM from the point of time of the completion of the exchange of the liquid LQ of the object plane-side space K1, and the controller CONT judges whether or not the elapsed time, elapsed after the point of time (i.e., Step S60) at which the exchange of the liquid LQ of the object plane-side space K1 is completed, exceeds the preset allowable value (Step S90).

When the exchange of the liquid LQ of the object plane-side space K1 is not performed after the completion of the first lot, it is appropriate that the controller CONT judges, in Step S90, whether or not the elapsed time elapsed after the point of time of the completion of the initial filling in Step S10 exceeds the predetermined allowable time.

If it is judged in Step S90 that the elapsed time elapsed after the point of time of the exchange of the liquid LQ of the object plane-side space K1 (i.e., the point of time of Step S60) is not less than the allowable value, the controller CONT exchanges the liquid LQ of the object plane-side space K1 (Step S100).

Specifically, the controller CONT exchanges the liquid LQ in accordance with the same procedure as the procedure explained, for example, with reference to Fig. 22.

After the exchange of the liquid LQ of the object plane-side space K1 is completed, the controller CONT executes the measurement process through the liquid LQ by using the various measuring devices provided on the measuring stage ST2 in the state in which the projection optical system PL is opposite to the measuring stage ST2 (Step S110). After performing the measurement process in relation to the exposure process via the liquid LQ, the image plane-side liquid immersion area LR2 is moved onto the substrate stage ST1 in the same manner as described above. The controller CONT successively exposes a predetermined number of the substrates P constituting the next third lot. The controller CONT successively exposes the predetermined number of the substrates P constituting the third lot in accordance with the same procedure as the procedure explained, for example, with reference to Fig. 21 (Step S120).

On the other hand, if it is judged in Step S90 that the elapsed time elapsed after the point of time of the exchange of the liquid LQ of the object plane-side space K1 is not more than the allowable value, then the controller CONT does not exchange the liquid LQ of the object plane-side space K1, and the controller CONT exposes the substrates P of the third lot through the liquid LQ filled in the object plane-side space K1.

As described above, it is judged whether or not the liquid LQ, filled in the object plane-side space K1, is to be exchanged based on the elapsed time elapsed after the point of time at which the liquid LQ is formerly exchanged, in order to expose the substrate P through the liquid LQ in the desired state. Accordingly, if the elapsed time is not less than the allowable value, the liquid LQ is exchanged to fill the object plane-side space K1 with the liquid LQ which has the desired temperature and cleanness. On the other hand, if the elapsed time is not more than the allowable value, it is possible to omit the operation in which the liquid LQ is exchanged even if the liquid LQ filled in the object plane-side space K1 is in the desired state.

In the followings, the controller CONT judges whether or not the elapsed time elapsed after the exchange of the liquid LQ filled in the object plane-side space K1 exceeds the preset allowable value in the same manner as described above (Step S130). If it is judged that the elapsed time elapsed after the point of time (Step S100) of the exchange of the liquid LQ of the object plane-side space K1 is not less than the allowable value, the controller CONT exchanges the liquid LQ of the object plane-side space K1 (Step S140). After that, the controller CONT performs the measurement process by using the measuring device provided on the measuring stage ST2 (Step S150), and then the controller CONT performs the exposure for the substrates P of the fourth lot (Step S160). On the other hand, if it is judged in Step S130 that the elapsed time elapsed after the point of time (Step S100) of the exchange of the liquid LQ of the object plane-side space K1 is not more than the allowable value, the controller CONT starts the exposure process for the substrates P of the fourth lot through the liquid LQ filled in the object plane-side space K1, without exchanging the liquid LQ of the object plane-side space K1.

Afterwards, the substrates P of the fifth, sixth... and the nth lots are successively exposed in the same manner as described above.

In the embodiment described above, the controller CONT starts the time measurement at the point of time at which the initial filling operation is completed or at the point of time at which the liquid exchange operation is completed. However, the point of time, at which the time measurement is to be started, can be appropriately determined, which may be, for example, a point of time at which each of the operations is started.

As explained above, it is judged whether or not the liquid LQ is to be exchanged based on the elapsed time elapsed after the completion of the initial filling operation for the object plane-side space K1 or the elapsed time elapsed after the exchange of the liquid LQ filled in the object plane-side space K1. Therefore, the liquid LQ is successfully allowed to be in the desired state. That is, if the elapsed time is not less than the allowable value (for example, 5 minutes), then the liquid LQ is exchanged by using the first liquid immersion mechanism 1, and thus the object plane-side space K1 is filled with the liquid LQ having the desired temperature. Therefore, it is possible to suppress the inconvenience which would be otherwise caused, for example, by the temperature change in the liquid LQ such that the optical path for the exposure light beam EL passing through the liquid LQ is fluctuated, and/or the first and second optical elements LS1, LS2 or the like, which make contact with the liquid LQ, are thermally deformed, resulting the deterioration of the exposure accuracy and the measurement accuracy through the liquid LQ. When the liquid LQ is exchanged, the object plane-side space K1 is filled with the liquid LQ which has the desired cleanness. Therefore, it is possible to suppress the inconvenience which would be otherwise caused by the pollution of the liquid LQ such that the light amount of the exposure light beam EL allowed to pass through the liquid LQ is lowered on the substrate P, and/or the first and second optical elements LS1, LS2, which make contact with the liquid LQ, are polluted, resulting in the deterioration of the exposure accuracy and the measurement accuracy through the liquid LQ. On the other hand, if the elapsed time is not more than the allowable value, it is possible to omit the operation in which the liquid LQ is exchanged even if the liquid LQ filled in the object plane-side space K1 is in the desired state. Therefore, it is possible to improve the rate of operation and the throughput of the exposure apparatus EX.

In this embodiment, after performing the exchange of the liquid LQ of the object plane-side space K1, the imaging characteristic (optical characteristic) is measured by using the spatial image-measuring sensor 160 provided on the measuring stage ST2, and/or the base line is measured by using the reference mark plate FM. Therefore, the exposure for the substrate, which is to be performed thereafter, can be executed highly accurately while considering the change of the imaging characteristic (optical characteristic) accompanied by the exchange of the liquid.

Also in this case, the following procedure is desirably adopted. That is, the base line is measured by using the reference mark plate FM provided on the measuring stage ST2, and/or the imaging characteristic (optical characteristic) is measured by using the spatial image-measuring sensor 160 after performing the exchange of the liquid of the object plane-side space K1. The exposure for the substrate, which is to be performed thereafter, is executed while considering the change of, for example, the imaging characteristic (optical characteristic) accompanied by the exchange of the liquid.

In this embodiment, when the initial filling operation is performed for the object plane-side space K1 and the image plane-side space K2, then the initial filling operation for the object plane-side space K1 is first performed to observe the state of the object plane-side liquid immersion area LR1, and then the state of the image plane-side liquid immersion area LR2 is observed. However, it is also allowable that the initial filling operation for the image plane-side space K2 is first performed to observe the state of the image plane-side liquid immersion area LR2, and then the state of the object plane-side liquid immersion area LR1 is observed. In this embodiment, when the liquid LQ is observed during the initial filling operation for the object plane-side space K1 by using the observing device 100, the image plane-side space K2 is not filled with the liquid LQ. However, it is also allowable that the image plane-side space K2 is filled with the liquid LQ. In this case, the observing device 100 observes the object plane-side liquid immersion area LR1 through the liquid LQ of the image plane-side liquid immersion area LR2. On the other hand, when the liquid LQ is observed during the initial filling operation for the object plane-side space K1, the observing device 100 can more highly accurately observe the presence or absence of the bubble in the liquid LQ filled in the object plane-side space K1, without filling the image plane-side space K2 with the liquid LQ.

In this embodiment, it is judged whether or not the liquid LQ is to be exchanged based on the elapsed time elapsed after the completion of the initial filling operation for the object plane-side space K1 or the elapsed time elapsed after the exchange of the liquid LQ filled in the object plane-side space K1; and then the liquid LQ is exchanged by using the first liquid immersion mechanism 1, based on the result of the judgment. On the other hand, as for the image plane-side space K2, the second liquid immersion mechanism 2 fills the image plane-side space K2 with the liquid LQ by concurrently continuing the supply operation for supplying the liquid LQ to the image plane-side space K2 and the recovery operation for recovering the liquid LQ from the image plane-side space K2 after the completion of the initial filling of the image plane-side space K2. However, the liquid LQ may be exchanged after the elapse of a predetermined period of time or every time when a predetermined period of time elapses, without continuously performing the supply and the recovery of the liquid LQ with respect to the image plane-side space K2. That is, the following procedure is also allowable. It is judged whether or not the liquid LQ is to be exchanged based on the elapsed time elapsed after the completion of the initial filling operation for the image plane-side space K2 or the elapsed time elapsed after the exchange of the liquid LQ filled in the image plane-side space K2, in the same manner as for the liquid LQ of the object plane-side space K1; and that the liquid LQ is exchanged (the supply operation and the recovery operation are performed for the liquid LQ of the image plane-side space K2) by using the second liquid immersion mechanism 2 (and the liquid recovery mechanism 90), based on the result of the judgment. After performing the liquid exchange or the initial filling operation for the image plane-side space K2, the state of the image plane-side liquid immersion area LR2 can be observed by using the observing device 100 (see Steps S20 to S25 shown in Fig. 20). As a result, the image plane-side space K2 is filled with the liquid LQ having the desired cleanness. Therefore, it is possible to suppress the inconvenience which would be otherwise caused by the pollution of the liquid LQ such that the light amount of the exposure light beam EL allowed to pass through the liquid LQ is lowered on the substrate P, and/or the first optical element LS1, which makes contact with the liquid LQ, is polluted, resulting in the deterioration of the exposure accuracy and the measurement accuracy via the liquid LQ. Further, the liquid supply operation and the liquid recovery operation of the second liquid immersion mechanism 2 can be stopped during the exposure. Therefore, it is possible to avoid the influence which would be exerted on the exposure operation by the liquid supply operation and the liquid recovery operation.

### Second Embodiment

In the embodiment described above, it is judged whether or not the liquid LQ, filled in the object plane-side space K1, is to be exchanged at the head of the lot, based on the elapsed time elapsed after the exchange of the liquid LQ filled in the object plane-side space K1. However, for example, it is also allowable to judge whether or not the liquid LQ of the object plane-side space K1 is to be exchanged while also considering the time required for the exposure of a predetermined number of the substrates P constructing the lot (for example, the third lot) scheduled after the judging step (For example, Step S90) .

For example, it is assumed that the allowable value is 5 minutes, and the time required to complete the exposure process for the third lot is 2 minutes. On this assumption, when it is judged in Step S90 whether or not the liquid LQ filled in the object plane-side space K1 is to be exchanged, if the elapsed time elapsed after the exchange of the liquid LQ of the object plane-side space K1 in Step S60 is 2 minutes, then it is judged in Step S90 that the liquid LQ, filled in the object plane-side space K1, is not to be exchanged. That is, the operation of Step S100 is omitted. However, if the process time, which is required to expose the predetermined number of the substrates P of the third lot, is, for example, 4 minutes, the elapsed time arrives at the allowable value in the middle of the exposure for the substrates P of the third lot. Accordingly, the controller CONT judges, in Step S90, it is appropriate to exchange the liquid, also considering the period of time required until the completion of the exposure process for the third lot, although the elapsed time does not exceed the allowable value; and the controller CONT proceeds the routine to Step S100 to execute the exchange of the liquid LQ of the object plane-side space K1.

As described above, it is judged whether or not the liquid LQ of the object plane-side space is to be exchanged, while considering not only the elapsed time elapsed after the former exchange of the liquid but also the period of time required for the exposure process for the next lot. Therefore, it is possible to avoid the liquid exchange during the exposure process for one lot including a predetermined number of the substrates.

In the first and second embodiments described above, the exchange operation for the liquid LQ of the object plane-side space K1 is performed for every lot including a predetermined number of the substrates. However, the exchange operation may be performed every time when a predetermined period of time elapses or every time when a predetermined number of the substrates are processed. Also in this case, the following procedure is desirably adopted. That is, the base line measurement using the reference mark plate FM provided on the measuring stage ST2 and/or the measurement of the imaging characteristic (optical characteristic) using the spatial image-measuring sensor 160 is performed after exchanging the liquid LQ of the object plane-side space K1; and the exposure for the substrate is executed thereafter while considering, for example, the imaging characteristic (optical characteristic) accompanied by the exchange of the liquid.

### Third Embodiment

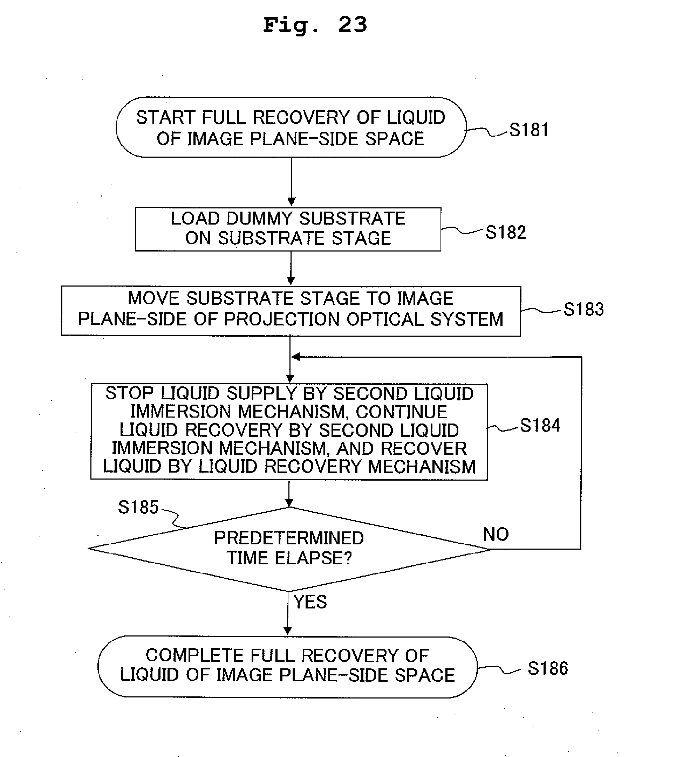

Next, an explanation will be made as a third embodiment with reference to a flow chart shown in Fig. 23 about an exemplary operation for recovering all of the liquid LQ filled in the image plane-side space K2.

After the predetermined process such as the exposure process for the substrate P is performed in the state in which the image plane-side space K2 is filled with the liquid LQ, all of the liquid LQ, filled in the image plane-side space K2, is fully recovered in some cases, for example, for the purpose of the maintenance of the apparatus. In the following description, an operation, in which all of the liquid LQ filling the image plane-side space K2 therewith is fully recovered, is appropriately referred to as "full recovery operation".

When an instruction to start the full recovery operation is issued (Step S181), then the controller CONT moves the substrate stage ST1 to the substrate exchange position RP, and a dummy substrate is loaded on the substrate stage ST1 by using the transport device H (Step S182). The dummy substrate is a substrate which is different from the substrate P for producing the device. However, the outer shape of the dummy substrate is approximately the same as that of the substrate P for producing the device. The substrate stage ST1 (substrate holder PH) is capable of holding the dummy substrate. The dummy substrate is liquid-repellent with respect to the liquid LQ. In this embodiment, the contact angle between the dummy substrate and the liquid LQ is approximately equal to the contact angle between the upper surface F1 of the substrate stage ST1 (i.e., the upper surface Ta of the plate member T) and the liquid LQ. The measuring stage ST2 is arranged at a position at which the measuring stage ST2 is opposite to the projection optical system PL in the same manner as in the embodiment described above, in the state in which the substrate stage ST1 is arranged at the substrate exchange position RP. The liquid LQ, which forms the image plane-side liquid immersion area LR2, is retained between the projection optical system PL and the measuring stage ST2.

Subsequently, as explained, for example, with reference to Fig. 9, the controller CONT brings the upper surface F1 of the substrate stage ST1 which holds the dummy substrate into contact with (or made to approach to) the upper surface F2 of the measuring stage ST2, and the controller CONT moves the measuring stage ST2 and the substrate stage ST1 together in the XY directions to move the substrate stage ST1 to the image plane-side of the projection optical system PL. Accordingly, the image plane-side liquid immersion area LR2, which is formed on the upper surface F2 of the measuring stage ST2, is moved to the upper surface F1 of the substrate stage ST1 including a surface of the dummy substrate (Step S183).

Subsequently, the controller CONT stops the liquid supply operation having been performed by the second liquid supply device 31 of the second liquid immersion mechanism 2. The controller CONT continues, for a predetermined period of time, the liquid recovery operation performed by the second liquid recovery device 41 of the second liquid immersion mechanism 2 even after the stop of the liquid supply operation having been performed by the second liquid supply device 31. Accordingly, the liquid LQ, filled in the image plane-side space K2, is recovered by the second liquid recovery device 41 via the recovery port 42 of the nozzle member 70 of the second liquid immersion mechanism 2. Further, the controller CONT executes the liquid recovery operation performed by the liquid recovery mechanism 90 provided for the substrate stage ST1 (substrate holder PH) as explained, for example, with reference to Fig. 7 concurrently with the liquid recovery operation performed by the second liquid immersion mechanism 2. That is, the controller CONT arranges the image plane-side liquid immersion area LR2 on the gap A formed between the dummy substrate and the plate member T, and the controller CONT performs the recovery of the liquid LQ by using the liquid recovery mechanism 90 provided for the substrate stage ST1. Accordingly, all of the liquid LQ can be recovered satisfactorily.

The controller CONT concurrently performs the liquid recovery operation by the second liquid immersion mechanism 2 and the liquid recovery operation by the liquid recovery mechanism 90 provided for the substrate stage ST1 while monitoring the timer TM. The controller CONT judges whether or not the elapsed time elapsed after the start of the full recovery operation for the liquid LQ, specifically the elapsed time elapsed after the stop of the liquid supply operation of the second liquid supply device 31 of the second liquid immersion mechanism 2 passes (exceeds) a preset predetermined period of time (Step S185).

The predetermined period of time is a time required to fully recover the liquid LQ, which is previously determined by an experiment or simulation.

If it is judged in Step S185 that the elapsed time elapsed after the start of the full recovery operation for the liquid LQ passes the predetermined period of time, the controller CONT completes the full recovery operation for the liquid LQ of the image plane-side space K2. On the other hand, if it is judged in Step S185 that the elapsed time elapsed after the start of the full recovery operation for the liquid LQ does not pass the predetermined period of time yet, the controller CONT continues the full recovery operation for the liquid LQ by using the second liquid immersion mechanism 2 and the liquid recovery mechanism 90.

The following procedure is also allowable. That is, after the full recovery operation for the liquid LQ is completed, the controller CONT allows the projection optical system PL (nozzle member 70) and the measuring stage ST2 to be opposite to each other, and confirms whether or not any liquid LQ remains on the projection optical system PL and/or the nozzle member 70 by using the observing device 100 provided for the measuring stage ST2.

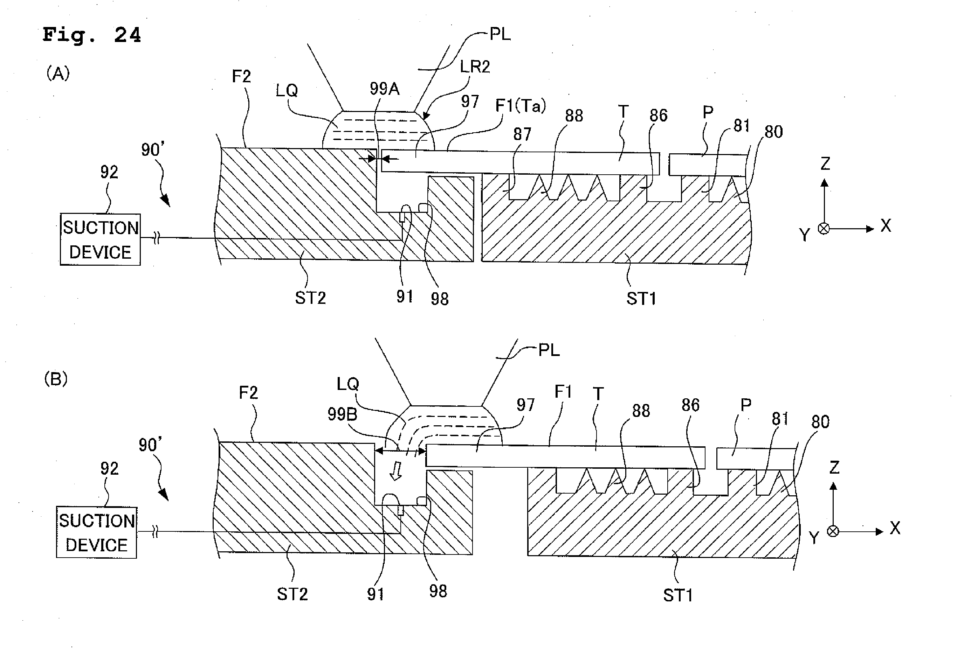

In this embodiment, the liquid recovery mechanism 90 is provided for the substrate stage ST1. However, the liquid recovery mechanism 90 may be provided for the measuring stage ST2. Fig. 24 shows an example of a liquid recovery mechanism 90' provided for the measuring stage ST2. With reference to Fig. 24, the circumferential edge area of the plate member T of the substrate stage ST1 overhangs to the outside of the fourth circumferential wall portion 87. A protrusion 97, which protrudes toward the measuring stage ST2, is formed in the substrate stage ST1 by an overhanging portion of the plate member T disposed on the -X side. A recess 98, which corresponds to the protrusion 97, is formed on the +X side of the measuring stage ST2. An area located in the vicinity of the protrusion 97 of the upper surface F1 (Ta) of the substrate stage ST1 and an area located in the vicinity of the recess 98 of the upper surface F2 of the measuring stage ST2 make contact with each other (or made to approach to each other). A recovery port 91 for recovering the liquid LQ is provided inside the recess 98 of the measuring stage ST2. A suction device 92 is connected, via a flow passage, to the recovery port 91.

Fig. 24(A) shows a situation in which the substrate stage ST1 and the measuring stage ST2 are moved together while maintaining the state in which the upper surface F1 of the substrate stage ST1 and the upper surface F2 of the measuring stage ST2 make contact with each other (or made to approach to each other). When the substrate stage ST1 and the measuring stage ST2 are in the state shown in Fig. 24(A), the protrusion 97 of the substrate stage ST1 is arranged over or above the recess 98 of the measuring stage ST2. Accordingly, the recovery port 91, which is provided at the inside of the recess 98, is closed by the protrusion 97 in the state shown in Fig. 24(A). When the substrate stage ST1 and the measuring stage ST2 are moved together while maintaining the state in which the upper surface F1 of the substrate stage ST1 and the upper surface F2 of the measuring stage ST2 make contact with each other (or made to approach to each other), the image plane-side liquid immersion area LR2 can be thus moved between the upper surface F1 of the substrate stage ST1 and the upper surface F2 of the measuring stage ST2. When the image plane-side liquid immersion area LR2 is moved in the state shown in Fig. 24(A), even if the liquid LQ leaks from the gap 99A between the upper surface F1 of the substrate stage ST1 and the upper surface F2 of the measuring stage ST2, the leaked liquid LQ is collected by the recess 98, because the recess 98 is provided under or below the gap 99A. Therefore, it is possible to avoid the occurrence of the inconvenience which would be otherwise caused such that the liquid LQ outflows to the outside of the stages ST1, ST2 and/or onto the base member BP. Further, the recovery port 91 of the liquid recovery mechanism 90' is provided at the inside of the recess 98. Therefore, the liquid LQ, which leaks from the gap, can be recovered by the aid of the recovery port 91.

Fig. 24(B) shows a situation in which the liquid LQ is recovered via the recovery port 91 of the liquid recovery mechanism 90'. When the liquid LQ of the image plane-side liquid immersion area LR2 is fully recovered, the controller CONT allows a relative positional relationship between the substrate stage ST1 and the measuring stage ST2 to be in the state as shown in Fig. 24(B). That is, the controller CONT controls the driving of the stage-driving devices SD1, SD2 to form a gap 99B between the upper surface F1 of the substrate stage ST1 and the upper surface F2 of the measuring stage ST2, and the controller CONT makes the recess 98 and the recovery port 91 provided at the inside thereof to be exposed. The controller CONT then performs the recovery of the liquid LQ by the recovery port 91 of the measuring stage ST2 while moving the substrate stage ST1 and the measuring stage ST2 together in the state in which the gap 99B is formed between the upper surface F1 of the substrate stage ST1 and the upper surface F2 of the measuring stage ST2 to expose the recovery port 91. When the substrate stage ST1 and the measuring stage ST2 are moved, and the gap 99B is arranged under or below the projection optical system PL, then the liquid LQ, which is retained under or below the projection optical system PL, is allowed to inflow into the recess 98 via the gap 99B in accordance with the action of the gravity, and the liquid LQ is recovered via the recovery port 91.

Also in this case, the controller CONT can concurrently perform the recovery operation for recovering the liquid LQ with the recovery port 91 provided for the measuring stage ST2 and the recovery operation by the second liquid immersion mechanism 2.

In the third embodiment also, the liquid LQ, which forms the image plane-side liquid immersion area LR2, may be fully recovered while moving at least one of the substrate stage ST1 and the measuring stage ST2 with respect to the first optical element LS1. In the third embodiment, the liquid LQ of the image plane-side space K2 is fully recovered by using the liquid recovery mechanism 90 (90'). However, the liquid LQ may be fully recovered by the liquid recovery operation by the second liquid immersion mechanism 2, without using the liquid recovery mechanism 90.

When the liquid LQ, which forms the image plane-side liquid immersion area LR2, is fully recovered, it is desirable that the liquid supply operation and the liquid recovery operation by the second liquid immersion mechanism 2 are continued for a predetermined period of time, for example, on a clean dummy substrate before stopping the liquid supply operation by the second liquid supply device 31 of the second liquid immersion mechanism 2. Accordingly, any eluted matter (pollutant), which results from the film material disposed on the surface of the substrate P, is removed from the liquid LQ which forms the image plane-side liquid immersion area LR2; and even when the liquid LQ, which remains on (adheres to) the surface of the first optical element LS1, is dried after fully recovering the liquid LQ forming the image plane-side liquid immersion area LR2, it is possible to suppress the appearance of adhesion trace (for example, water mark).

When the state, in which the surface of the first optical element LS1 does not make contact with the liquid LQ, is continued for a long period of time after fully recovering the liquid LQ forming the image plane-side liquid immersion area LR2, it is desirable to dry the surface of the first optical element LS1 by allowing the clean gas to blow against the surface of the first optical element LS1 and/or sucking the gas in the vicinity of the surface of the first optical element LS1 so that any adhesion trace (for example, any water mark) of the liquid LQ does not appear on the surface of the first optical element LS1. When the liquid LQ of the image plane-side space K2 is fully recovered, the object plane-side space K1 may be maintained to be filled with the liquid LQ. Alternatively, the liquid LQ of the object plane-side space K1 may be also fully recovered by performing only the liquid recovery operation by the first liquid immersion mechanism 1.

### Fourth Embodiment

Next, an operation, which is to be performed when the exposure light beam EL is not radiated, will be explained as a fourth embodiment as exemplified by an operation to be performed during the stop of the radiation of the exposure light beam EL.

After performing the predetermined process such as the exposure process for the substrate P through the liquid LQ, the radiation of the exposure light beam EL is stopped to maintain the idling state for a predetermined period of time in some cases. In this embodiment, the supply operation and the recovery operation for supplying and recovering the liquid LQ by the second liquid immersion mechanism 2 are continuously performed in continuity to continuously fill the image plane-side space K2 with the liquid LQ even during the stop of the radiation of the exposure light beam EL.

In this embodiment, the object plane-side space K1 is filled with the liquid LQ as well during the stop of the radiation of the exposure light beam EL. However, the supply operation and the recovery operation for supplying and recovering the liquid LQ by the first liquid immersion mechanism 1 are stopped. That is, in this state, the liquid LQ stays or remains in the object plane-side space K1 during the stop of the radiation of the exposure light beam EL.

If the state, in which the liquid LQ stays in the object plane-side space K1, is left to stand for a long period of time, there is such a possibility that the liquid LQ may be polluted, and the first and second optical elements LS1, LS2, which make contact with the liquid LQ, may be consequently polluted. If the first and second optical elements LS1, LS2 are polluted, even when the clean liquid LQ is supplied to the object plane-side space K1, then an inconvenience arises such that the supplied liquid LQ is consequently polluted by making contact with the first and second optical elements LS1, LS2. In view of the above situation, when the exposure light beam EL is not radiated (during the stop of the radiation in this embodiment), the controller CONT exchanges the liquid LQ filled in the object plane-side space K1 between the first optical element LS1 and the second optical element LS2, at predetermined time intervals (for example, once per 15 minutes) by using the first liquid immersion mechanism 1. Accordingly, it is possible to suppress the pollution of the liquid LQ, and it is possible to allow the liquid LQ filled in the object plane-side space K1 to be in the desired state. It is possible to suppress the influence exerted by the liquid LQ on the first and second optical elements LS1, LS2, and it is possible to quickly start the exposure process for the next lot.

The liquid LQ, filled in the object plane-side space K1 between the first optical element LS1 and the second optical element LS2, can be exchanged at predetermined time intervals (for example, once per 15 minutes) by using the first liquid immersion mechanism 1, when the exposure light beam EL is not radiated, without the exchange being limited to the period in which the radiation of the exposure light beam EL is stopped. For example, the liquid LQ, filled in the object plane-side space K1 between the first optical element LS1 and the second optical element LS2, can be exchanged at predetermined time intervals by using the first liquid immersion mechanism 1, for example, before the exposure process for the substrate P is performed, or when the radiation of the exposure light beam is delayed or not performed due to any cause.

In the fourth embodiment, the explanation has been made about the operation wherein the liquid LQ, filled in the object plane-side space K1 between the first optical element LS1 and the second optical element LS2, is exchanged by using the first liquid immersion mechanism 1, when the exposure light beam EL is not radiated. However, the exchange is not limited to this. The liquid LQ, filled in the object plane-side space K1 between the first optical element LS1 and the second optical element LS2, may be exchanged by using the first liquid immersion mechanism 1, when the exposure light beam EL is radiated. When the exchange is performed at a predetermined timing without continuously performing the supply and the recovery of the liquid LQ with respect to the image plane-side space K2, it is also allowable to exchange the liquid LQ of the image plane-side space K2 when the radiation of the exposure light beam EL is not performed.

In the first to fourth embodiments described above, the object plane-side liquid immersion area LR1 is locally formed on a part of the upper surface of the first optical element LS1. However, the object plane-side liquid immersion area LR1 may be formed to cover the substantially entire area of the upper surface of the first optical element LS1. In this case, there is a possibility that the liquid LQ, filled in the object plane-side space K1, makes contact with any member such as the barrel PK which is different from the first and second optical elements LS1, LS2. However, by exchanging the liquid LQ, it is possible to avoid the inconvenience which would be otherwise caused such that the member such as the barrel PK, which makes contact with the liquid LQ, is thermally deformed and/or polluted due to the liquid LQ.

In the first to fourth embodiments, the observing device 100 has the field which is larger than the liquid immersion areas LR1, LR2. However, it is also allowable that the observing device 100 has a field which is smaller than the liquid immersion areas LR1, LR2. In this case, the entire regions of the liquid immersion areas LR1, LR2 can be satisfactorily observed respectively by performing the observation while moving the measuring stage ST2 on which the observing device 100 is provided, in the XY directions with respect to the projection optical system PL, i.e., moving the liquid immersion areas LR1, LR2 relative to the field of the observing device 100. In the embodiments described above, it is judged whether or not the object plane-side space K1 and the image plane-side space K2 are filled with the liquid LQ, by using the observing device 100. However, when the object plane-side space K1 is hardly contaminated with the bubble (gas), it is also allowable that the observing device 100 is used for only the image plane-side space K2.

In the first to fourth embodiments described above, the first liquid immersion mechanism 1 and the second liquid immersion mechanism 2 are provided with the degassing devices and the temperature regulation devices which are distinct from each other. However, a part or parts of the degassing device and the like may be commonly used.

In the first to fourth embodiments described above, the first liquid immersion mechanism 1 and the second liquid immersion mechanism 2 supply the common liquid LQ (pure water). However, the first liquid immersion mechanism 1 and the second liquid immersion mechanism 2 may supply mutually different liquids. In this case, the first liquid immersion mechanism 1 and the second liquid immersion mechanism 2 may supply liquids of different types (for example, having different refractive indexes) respectively. Alternatively, a liquid of an identical type may be supplied while allowing a part of property such as the temperature to differ. In the first to fourth embodiments described above, the explanation has been made about the filling operation and the exchange operation for the liquid LQ in the optical path space (object plane-side space K1) between the first optical element LS1 arranged opposite to the substrate P and the second optical element LS2 arranged on the light-incident side of the first optical element LS1 and/or the optical path space (image plane-side space K2) on the light-exit side of the first optical element LS1. However, the optical path space is not limited thereto. The filling operation and the exchange operation as described above are applicable to any optical path space provided that the optical path space is to be filled with the liquid LQ.

As described above, pure water is used as the liquid LQ in the embodiment of the present invention. Pure water is advantageous in that pure water is available in a large amount with ease, for example, in the semiconductor production factory, and pure water exerts no harmful influence, for example, on the optical element (lens) and the photoresist on the substrate P. Further, pure water exerts no harmful influence on the environment, and the content of impurity is extremely low. Therefore, it is also expected to obtain the function to wash or clean the surface of the substrate P and the surface of the optical element provided at the end surface of the projection optical system PL. When the purity of pure water supplied from the factory or the like is low, it is also allowable that the exposure apparatus is provided with an ultra pure water-producing device.

It is approved that the refractive index n of pure water (water) with respect to the exposure light beam EL having a wavelength of about 193 nm is approximately 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In the embodiment of the present invention, the optical element LS1 is attached to the end portion of the projection optical system PL. The lens makes it possible to adjust the optical characteristics of the projection optical system PL, for example, the aberration (for example, spherical aberration and coma aberration). The optical element, which is attached to the end portion of the projection optical system PL, may be an optical plate which is usable to adjust the optical characteristics of the projection optical system PL. Alternatively, the optical element may be a plane-parallel through which the exposure light beam EL is transmissive.

When the pressure, which is generated by the flow of the liquid LQ, is large between the substrate P and the optical element at the end portion of the projection optical system PL, it is also allowable that the optical element is tightly fixed so that the optical element is not moved by the pressure, instead of allowing the optical element to be exchangeable. The structure of the liquid immersion mechanism 1 including, for example, the nozzle member 70 is not limited to the structure described above. It is possible to use those described, for example, in European Patent Publication No. 1420298, and International Publication Nos. 2004/055803, 2004/057590, and 2005/029559.

In the embodiment of the present invention, the space between the projection optical system PL and the surface of the substrate P is filled with the liquid LQ. However, for example, the space may be filled with the liquid LQ in such a state that a cover glass constructed of a plane-parallel is attached to the surface of the substrate P.

The liquid LQ is water in the embodiment of the present invention. However, the liquid LQ may be any liquid other than water. For example, when the light source of the exposure light beam EL is the F₂ laser, the F₂ laser beam is not transmitted through water. Therefore, those preferably usable as the liquid LQ may include, for example, fluorine-based fluids such as fluorine-based oil and perfluoropolyether (PFPE) through which the F₂ laser beam is transmissive. In this case, a portion, which makes contact with the liquid LQ, is subjected to a liquid-attracting treatment by forming, for example, a thin film with a substance including fluorine which has a molecular structure with small polarity. Alternatively, other than the above, it is also possible to use, as the liquid LQ, liquids (for example, cedar oil) which have the transmittance with respect to the exposure light beam EL, which have the refractive index as high as possible, and which are stable against the photoresist coated on the surface of the substrate P and the projection optical system PL.

Liquids having refractive indexes of about 1.6 to 1.8 may be used as the liquid LQ. Further, the optical element LS1 may be formed of a material having a refractive index (for example, not less than 1.6) higher than those of silica glass and calcium fluoride. It is also possible to use, as the liquid LQ, various liquids including, for example, supercritical fluids.

The substrate P, which is usable in the respective embodiments described above, is not limited to the semiconductor wafer for producing the semiconductor device. Substrates applicable include, for example, a glass substrate for the display device, a ceramic wafer for the thin film magnetic head, and a master plate (synthetic silica glass, silicon wafer) for the mask or the reticle to be used for the exposure apparatus.

As for the exposure apparatus EX, the present invention is also applicable to a scanning type exposure apparatus (scanning stepper) based on the step-and-scan system for performing the scanning exposure with the pattern of the mask M by synchronously moving the mask M and the substrate P as well as a projection exposure apparatus (stepper) based on the step-and-repeat system for performing the full field exposure with the pattern of the mask M in a state in which the mask M and the substrate P are allowed to stand still, while successively step-moving the substrate P.

As for the exposure apparatus EX, the present invention is also applicable to an exposure apparatus based on the system in which the full field exposure is performed on the substrate P by using a projection optical system (for example, the dioptric type projection optical system having a reduction magnification of 1/8 and including no catoptric element) with a reduction image of a first pattern in a state in which the first pattern and the substrate P are allowed to substantially stand still. In this case, the present invention is also applicable to a full field exposure apparatus based on the stitch system in which the full field exposure is further performed thereafter on the substrate P by partially overlaying a reduction image of a second pattern with respect to the first pattern by using the projection optical system in a state in which the second pattern and the substrate P are allowed to substantially stand still. As for the exposure apparatus based on the stitch system, the present invention is also applicable to an exposure apparatus based on the step-and-stitch system in which at least two patterns are partially overlaid and transferred on the substrate P, and the substrate P is successively moved. The embodiments described above have been explained as exemplified by the exposure apparatus provided with the projection optical system PL by way of example. However, the present invention is applicable to an exposure apparatus and an exposure method in which the projection optical system PL is not used. Even when the projection optical system PL is not used as described above, the exposure light beam is radiated onto the substrate via an optical member such as a lens, and the liquid immersion area is formed in a predetermined space between such an optical member and the substrate.

The present invention is also applicable to a twin-stage type exposure apparatus. The structure and the exposure operation of the twin-stage type exposure apparatus are disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407, contents of which are incorporated herein by reference within a range of permission of the domestic laws and ordinances of the state designated or selected in this international application.

In the embodiments described above, the light-transmissive type mask is used, in which the predetermined light-shielding pattern (or phase pattern or dimming or light-reducing pattern) is formed on the light-transmissive substrate. However, in place of such a mask, as disclosed, for example, in United States Patent No. 6,778,257, it is also allowable to use an electronic mask on which a transmissive pattern, a reflective pattern, or a light-emitting pattern is formed based on the electronic data of the pattern to be subjected to the exposure.

The present invention is also applicable to the exposure apparatus (lithography system) in which the substrate P is exposed with a line-and-space pattern by forming interference fringes on the substrate P as disclosed in International Publication No. 2001/035168.

As described above, the exposure apparatus EX according to the embodiment of the present invention is produced by assembling the various subsystems including the respective constitutive elements as defined in claims so that the predetermined mechanical accuracy, electric accuracy, and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

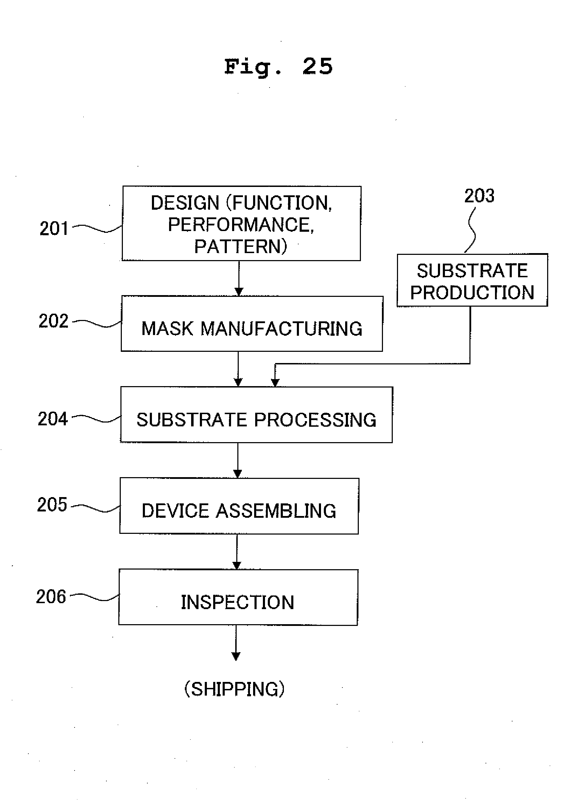

As shown in Fig. 25, the microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, a substrate-processing (exposure process) step 204 of exposing the substrate with the pattern of the mask by using the exposure apparatus EX of the embodiment described above and developing the exposed substrate, a step 205 of assembling the device (including processing processes such as a dicing step, a bonding step, and a packaging step), and an inspection step 206.

### INDUSTRIAL APPLICABILITY

As for the type of the exposure apparatus EX, the present invention is not limited to the exposure apparatus for the semiconductor device production which exposes the substrate P with the semiconductor device pattern. The present invention is also widely applicable, for example, to an exposure apparatus for producing the liquid crystal display device or for producing the display as well as an exposure apparatus for producing, for example, the thin film magnetic head, the image pickup device (CCD), the reticle, or the mask.

## Claims

1. An exposure method for exposing a substrate by radiating an exposure light beam onto the substrate via an optical system having a first optical element which is arranged opposite to the substrate and a second optical element, the exposure method comprising:
a first step for filling, with a liquid, a predetermined optical path space for the exposure light beam in the optical system or exchanging the liquid filled in the optical path space;
a second step for successively exposing, after the first step, a predetermined number of the substrate through the liquid filled in the optical path space; and
a third step for judging, after the second step, whether or not the liquid, filled in the optical path space, is to be exchanged based on an elapsed time elapsed after the first step has been performed.

2. The exposure method according to claim 1, wherein the liquid is not exchanged in the third step when the elapsed time is not more than an allowable value.

3. The exposure method according to claim 1, wherein the substrate is exposed through the liquid filled in the optical path space, after the third step.

4. The exposure method according to claim 1, wherein a judgment is made whether or not the liquid is to be exchanged in the third step considering a process time required to expose the predetermined number of the substrate scheduled after the third step.

5. The exposure method according to claim 1, wherein after exchanging the liquid, measurement is performed in relation to an exposure process through the liquid before exposing the substrate.

6. The exposure method according to claim 5, wherein the measurement includes measurement of an imaging characteristic via the liquid and a projection optical system including the first optical element and the second optical element.

7. The exposure method according to claim 6, wherein the imaging characteristic, which is obtained via the projection optical system and the liquid, is adjusted based on a result of the measurement.

8. The exposure method according to claim 1, wherein the optical path space is subjected to initial filling with the liquid in the first step; and
the exposure method further comprises:
a fourth step for exchanging the liquid, filled in the optical path space, when a judgment is made in the third step that the liquid is to be exchanged;
a fifth step for successively exposing, after the fourth step, a predetermined number of the substrate through the liquid filled in the optical path space; and
a sixth step for judging, after the fifth step, whether or not the liquid filled in the optical path space is to be exchanged, based on an elapsed time elapsed after the fourth step has been performed.

9. The exposure method according to claim 5, wherein the measurement and the exposure are performed at different positions.

10. The exposure method according to claim 1, wherein the predetermined optical path space includes an optical path space between the first optical element and the second optical element.

11. The exposure method according to claim 1, wherein the predetermined optical path space includes an optical path space on a light-exit side of the first optical element; and
the first step is executed in a state that the first optical element is opposite to an object which is different from the substrate.

12. An exposure method for exposing a substrate by radiating an exposure light beam onto the substrate via an optical system having a first optical element which is arranged opposite to the substrate and a second optical element, the exposure method comprising:
a liquid exchange step for exchanging, at a predetermined time interval, the liquid filled in a predetermined optical path space for the exposure light beam in the optical system, when the exposure light beam is not radiated; and
an exposure step for exposing the substrate by radiating the exposure light beam via the predetermined optical path space filled with the liquid, after exchanging the liquid at the predetermined time interval.

13. The exposure method according to claim 1 or 12,
wherein the exchange of the liquid includes an operation in which a supply operation for supplying the liquid to the optical path space and a recovery operation for recovering the liquid from the optical path space are concurrently performed in a state in which the optical path space is filled with the liquid.

14. The exposure method according to claim 1 or 12,
wherein a space between the first optical element and the substrate is filled with the liquid.

15. The exposure method according to claim 12, further comprising, before the liquid exchange step, a step for radiating the exposure light beam onto the substrate through the liquid filled in the predetermined optical path space;
wherein the radiation of the exposure light beam is stopped in the liquid exchange step; and
the liquid, filled in the predetermined optical path space, is exchanged at a predetermined time interval during a period in which the radiation of the exposure light beam is stopped.

16. The exposure method according to claim 12,
wherein the predetermined optical path space includes an optical path space between the first optical element and the second optical element.

17. The exposure method according to claim 12,
wherein the predetermined optical path space includes an optical path space on a light-exit side of the first optical element, and the liquid exchange step is executed in a state that the first optical element is opposite to an object which is different from the substrate.

18. An exposure apparatus which exposes a substrate by radiating an exposure light beam onto the substrate via an optical system having a first optical element which is arranged opposite to the substrate and a second optical element, the exposure apparatus comprising:
a first liquid immersion mechanism which fills, with a liquid, a predetermined optical path space for the exposure light beam in the optical system and which exchanges the liquid filled in the optical path space; and
a controller which controls the first liquid immersion mechanism;
wherein the controller controls the first liquid immersion mechanism to fill the optical path space with the liquid or to exchange the liquid filled in the optical path space at a first point of time, and then the controller performs an exposure process for successively exposing a predetermined number of the substrate through the liquid which is filled in the optical path space or which is exchanged; and
the controller judges, after completing the exposure for the predetermined number of the substrate, whether or not the liquid in the optical path space is to be exchanged by using the first liquid immersion mechanism based on an elapsed time elapsed after the first point of time.

19. The exposure apparatus according to claim 18, further comprising a measuring device which is provided on a side of a light-exit surface of the first optical element and which performs measurement in relation to the exposure process, wherein the controller controls the measuring device to perform the measurement before exposing the substrate.

20. The exposure apparatus according to claim 19, further comprising a measuring stage which is provided with the measuring device, and a substrate stage on which the substrate is exposed.

21. The exposure apparatus according to claim 18,
wherein the predetermined optical path space includes an optical path space between the first optical element and the second optical element.

22. The exposure apparatus according to claim 21, further comprising a second liquid immersion mechanism which fills, with the liquid, an optical path space between the first optical element and the substrate.

23. The exposure apparatus according to claim 18,
wherein the predetermined optical path space includes an optical path space on a light-exit side of the first optical element, and the exchange of the liquid is executed in a state that the first optical element is opposite to an object which is different from the substrate.

24. An exposure apparatus which exposes a substrate by radiating an exposure light beam onto the substrate via an optical system having a first optical element which is arranged opposite to the substrate and a second optical element, the exposure apparatus comprising:
a first liquid immersion mechanism which fills, with a liquid, a predetermined optical path space for the exposure light beam in the optical system and which exchanges the liquid filled in the optical path space; and
a controller which controls the first liquid immersion mechanism to exchange the liquid, filled in the optical path space, at a predetermined time interval when the exposure light beam is not radiated.

25. The exposure apparatus according to claim 24,
wherein the predetermined optical path space includes an optical path space between the first optical element and the second optical element.

26. The exposure apparatus according to claim 25, further comprising a second liquid immersion mechanism which fills, with the liquid, an optical path space for the exposure light beam between the first optical element and the substrate.

27. The exposure apparatus according to claim 24,
wherein the predetermined optical path space includes an optical path space on a light-exit side of the first optical element, and the exchange of the liquid is executed in a state that the first optical element is opposite to an object which is different from the substrate.

28. An exposure apparatus which exposes a substrate by radiating an exposure light beam onto the substrate via an optical system having a first optical element and a second optical element, the exposure apparatus comprising:
a first liquid immersion mechanism which fills, with a liquid, an optical path space for the exposure light beam between the first optical element and the second optical element and which exchanges the liquid filled in the optical path space;
a measuring device which is arranged on a side of a light-exit surface of the first optical element and which receives the exposure light beam through the liquid between the first optical element and the second optical element to perform predetermined measurement in relation to an exposure process; and
a controller which controls the first liquid immersion mechanism to execute an exchange operation for the liquid and which controls the measuring device to execute the measurement before starting the exposure for a next substrate, after the exchange operation for the liquid.

29. The exposure apparatus according to claim 28,
wherein the first liquid immersion mechanism exchanges the liquid during only a period in which the radiation of the exposure light beam is stopped.

30. The exposure apparatus according to claim 29, further comprising a measuring stage which is provided with the measuring device, and a substrate stage on which the substrate is exposed.

31. The exposure apparatus according to claim 28, further comprising a second liquid immersion mechanism which fills, with the liquid, an optical path space for the exposure light beam between the first optical element and the substrate.

32. An exposure method for exposing a substrate by radiating an exposure light beam onto the substrate through a liquid, the exposure method comprising:
exchanging the liquid;
performing measurement in relation to an exposure process through the exchanged liquid; and
exposing, after the measurement, the substrate by radiating the exposure light beam onto the substrate through the exchanged liquid.

33. The exposure method according to claim 32,
wherein the substrate is irradiated with the exposure light beam via an optical system and the liquid; and the liquid, filled in a space on a side of an image plane of the optical system, is exchanged.

34. The exposure method according to claim 32,
wherein the substrate is irradiated with the exposure light beam via first and second optical elements and the liquid which is filled in an optical path space between the optical elements; and the liquid, filled in the optical path space between the first and second optical elements, is exchanged.

35. The exposure method according to claim 32,
wherein the liquid is exchanged after a predetermined period of time is elapsed after providing or exchanging the liquid.

36. The exposure method according to claim 32,
wherein the liquid is exchanged when the exposure light beam is not radiated.

37. A method for producing a device, comprising exposing a substrate by using the exposure method as defined in any one of claims 1, 12, and 32; developing the exposed substrate; and processing the developed substrate.

38. An exposure apparatus which exposes a substrate by radiating an exposure light beam onto the substrate through a liquid, the exposure apparatus comprising:
a liquid immersion mechanism which exchanges the liquid; and
a measuring device which performs measurement in relation to an exposure process by receiving the exposure light beam through the liquid, after the liquid is exchanged.

39. The exposure apparatus according to claim 38, further comprising an optical system onto which the exposure light beam is radiated, wherein the substrate is irradiated with the exposure light beam via the optical system and the liquid, and the liquid immersion mechanism exchanges the liquid filled in a space on a side of an image plane of the optical system.

40. The exposure apparatus according to claim 38, further comprising an optical system which has first and second optical elements, wherein the substrate is irradiated with the exposure light beam through the liquid filled in an optical path space between the first and second optical elements, and the liquid immersion mechanism exchanges the liquid filled in the optical path space between the first and second optical elements.

41. The exposure apparatus according to claim 38, further comprising a measuring stage which is provided with the measuring device, and a stage on which the exposure process is performed and which is different from the measuring stage.

42. A method for producing a device, comprising exposing a substrate by using the exposure apparatus as defined in any one of claims 18, 24, 28, and 38; developing the exposed substrate; and processing the developed substrate.
